# EUROPEAN PATENT SPECIFICATION

(11) **EP 1 683 214 B1**
(45) Date of publication and mention of the grant of the patent: **21.03.2007**
(21) Application number: 04810721.3
(22) Date of filing: 10.11.2004
(51) Int. Cl.: H01L 51/30, H01L 51/40

(54) **PROCESS FOR FORMING ORGANIC LAYERS WITH A REGION INCLUDING A GUEST MATERIAL AND ORGANIC ELECTRONIC DEVICES INCORPORATING THE SAME**
PROZESS ZUR BILDUNG ORGANISCHER SCHICHTEN MIT EINER REGION MIT EINEM GASTMATERIAL UND ELEKTRONISCHE ORGANISCHE BAUELEMENTE DAMIT
PROCEDE DE FORMATION DE COUCHES ORGANIQUES PRESENTANT UNE ZONE QUI COMPREND UN MATERIAU INVITE ET DISPOSITIFS ELECTRONIQUES ORGANIQUES COMPORTANT LEDIT MATERIAU

(30) Priority: 10.11.2003 US 705321; 13.07.2004 US 889883
(43) Date of publication of application: 26.07.2006
(73) Proprietor: E.I. DUPONT DE NEMOURS AND COMPANY, Wilmington, Delaware 19898 (US)
(72) Inventor: MACPHERSON, Charles, Douglas, Santa Barbara, California 93111 (US); QUI, Chengfeng, Goleta, California 93117 (US); SRDANOV, Gordana, Santa Barbara, California 93111 (US); STAINER, Matthew, Goleta, California 93117 (US); YU, Gang, Santa Barbara, California 93111 (US)
(74) Representative: Hughes, Andrea Michelle
(86) International application number: PCT/US2004/037599
(87) International publication number: WO 2005/048373

(56) References cited:
- WO-A-00/12226
- WO-A-02/02714
- DE-A1- 19 918 193
- MUELLER, C. DAVID ET AL: "Multicolor organic light-emitting displays by solution processing" NATURE (LONDON, UNITED KINGDOM) , 421, 829-833 CODEN: NATUAS; ISSN: 0028-0836, no. 6925, 20 February 2003 (2003-02-20), XP008043932
- CHARLIE MACPHERSON 1 ET AL: "39.4: Development of Full Color Passive PLED Displays by Inkjet Printing" SID 03 DIGEST, vol. XXXIV, 30 May 2003 (2003-05-30), pages 1191-1193, XP007008330

## Description

### FIELD OF THE INVENTION

The invention relates generally to organic materials and organic electronic devices, and more specifically, to organic materials with regions including guest material(s) and processes for forming an organic layer and organic electronic devices incorporating such an organic layer and processes for using such devices.

### BACKGROUND OF THE INVENTION

Organic electronic devices have attracted increasing attention in recent years. Examples of organic electronic device include Organic Light-Emitting Diodes ("OLEDs"). Current research in the production of full color OLEDs is directed toward the development of cost effective, high throughput processes for producing color pixels. For the manufacture of monochromatic displays, spin-coating processes have been widely adopted. However, manufacture of full color displays usually requires certain modifications to procedures used in manufacture of monochromatic displays. For example, to make a display with full color images, each display pixel is divided into three subpixels, each emitting one of the three primary colors: red, green, and blue. This division of full-color pixels into three subpixels has resulted in a need to modify current processes for depositing different organic polymeric materials onto a single substrate during the manufacture of OLED displays.

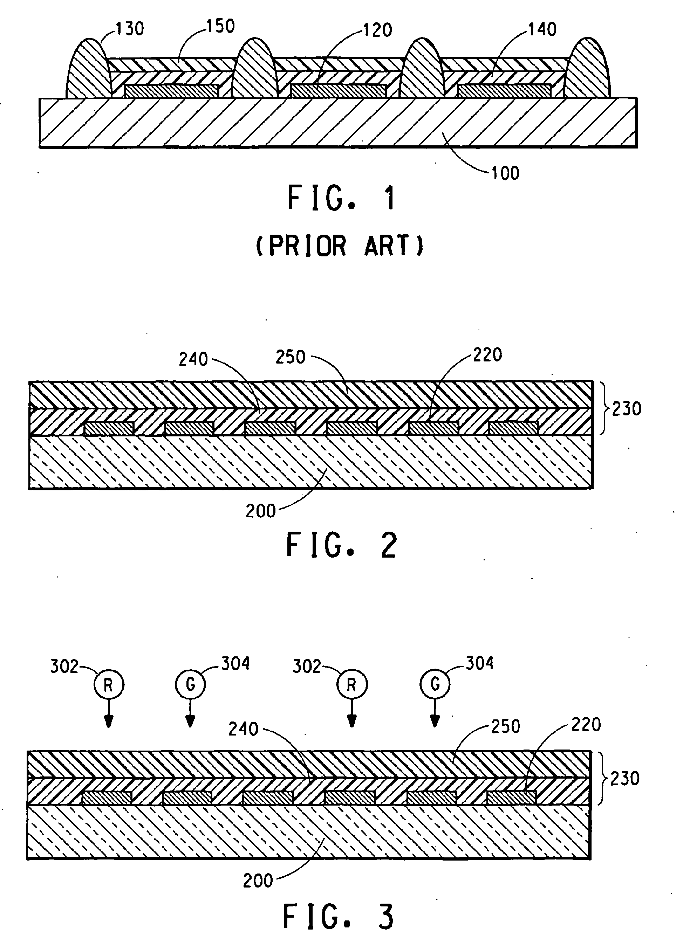

One such process for depositing organic material layers on a substrate is ink-jet printing. Referring to FIG. 1, first electrodes 120 (e.g., anodes) are formed over a substrate 100. In addition, in order to form pixels and subpixels, well structures 130 are formed on the substrate 100 to confine the ink drops to certain locations on the substrate 100. The well structures 130 typically are 2-5 microns thick and are made of an electrical insulator. A charge-transport layer 140 (e.g., a hole-transport layer) and organic active layer 150 may be formed by sequentially ink jet printing each of the layers 140 and 150 over the first electrodes 120.

One or more guest materials may or may not be mixed with the organic active layer 150. For example, the organic active layer 150 between the well structures 130 closest to the left-hand side of FIG. 1 may include a red guest material, and the organic active layer 150 between the well structures 130 near the center of FIG. 1 may include a green guest material, and the organic active layer 150 between the well structures 130 closest to the right-hand side of FIG. 1 may include a blue guest material. The well structures 130 tend to reduce the aperture ratio of a display, and therefore, higher current is needed to achieve sufficient emission intensity as seen by a user of the display.

In an alternative process, the charge transport layer 140 and organic active layer 150 may be formed with or without a well structure. Inks with different guest materials may be placed on regions of the organic active layer 150. The inks may include a conjugated polymer. After the ink is placed on the organic active layer 150, a diffusion step is performed to drive guest material from the overlying polymer into the organic active layer 150. A second electrode (not shown) is formed over the organic active layer 150 and the ink.

Many problems occur when using this process for organic electronic devices formed by such processes. First, most of the guest material does not diffuse into the organic active layer 150. Typically, 25% or less of the guest material from the ink is diffused into the organic active layer 150. Therefore most of the guest material lies outside the organic active layer 150.

Second, the organic electronic components formed using this ink diffusion process have poor efficiency. As a basis for comparison, the same host material (as the organic active layer 150) and guest material may be mixed before the organic active layer is formed over the substrate. The combination of the host material and guest material may be spin coated and subsequently processed to form an organic electronic component. The spin-coated organic electronic component will be referred to as a corresponding conventional organic electronic component because the organic active layer has the same host material and guest material as the diffused component. Organic electronic components formed by the ink diffusion process have efficiencies that are lower than their corresponding conventional organic electronic components. Due to lower efficiency, the organic electronic components formed using the ink diffusion process have intensities too low to be used for commercially-sold displays.

Third, the diffusion process causes a very non-uniform distribution of guest material concentration, resulting in a high concentration gradient (change in concentration divided by distance) between electrodes with an organic electronic device. The guest material concentration within the organic active layer 150 near the second electrode is typically at least two and usually several orders of magnitude higher than the guest material concentration within the organic active layer 150 near the first electrodes 120. The high guest material concentration gradient makes the display nearly impossible to use, particularly over time. As the potential difference between the first and second electrodes are changed, the location for recombination of electrons and holes within the organic active layer 150 also changes, moving closer to or further from first electrodes 120 (depending on the relative change in potential difference). When the recombination is closer to the second electrode, more guest material is present at the recombination location. When the recombination is closer to the first electrode 120, less guest material is present at the recombination location.

The guest material concentration gradient in the organic active layer 150 causes a different spectrum to be emitted from the organic electronic component as the potential difference between the first and second electrodes changes. Note that higher intensity is typically achieved by increasing the current, which in turn typically occurs by increasing the potential difference between the first and second electrodes. Therefore, intensity control of a single color (i.e., "gray-scale") is difficult because the emission spectrum shifts with a change in intensity, both of which are caused by a change in the potential difference between the first and second electrodes.

As a component ages, the amount of current needed for the same intensity typically increases. If the host material is capable of emitting blue light, as the intensity decays over time and current is increased (to try to keep intensity relatively constant over time), the emission of red and green doped pixels may become more blue with respect to their initial characteristic emission.

Fourth, the ink diffusion process is nearly impossible to use in manufacturing because of the sensitivity to thickness of the organic active layer 150. Relatively small changes in thickness can have a large impact on the guest material concentration profile within the organic active layer 150. For displays, a user will observe variation from display to display, or even within the array of a single display, due to variation in the thickness of the organic active layer 150 during the fabrication process.

A different conventional process uses a vapor or solid phase diffusion process. Both processes suffer from similar problems previously described. If the diffusion is long enough to make the concentration of a guest material more uniform throughout a thickness of the layer (i.e., reduce the concentration gradient between the electrodes), lateral diffusion will be too large and can result in low resolution because the pixels will need to be large. Alternatively, if lateral diffusion can be kept at an acceptable level for high resolution, the doping concentration gradient throughout the thickness of the organic layer may be unacceptably large. In some instances, both problems may occur (i.e., unacceptably large laterally diffusion while having too severe of a concentration gradient between the electrodes of the organic electronic device). Relevant prior art documents disclosing OLEDs and methods for making them include for instance C. Mueller et al., Nature, vol. 421,829-833, C. Mac Pherson et al., SIDO3 Digest, vol. XXXIV, 1191-1193, WO-A-OO/12226 or DE-A-1 9918193.

### SUMMARY OF THE INVENTION

Provided is a process for forming organic layers includes forming a first organic layer including at least one organic material over a substrate, and incorporating at least one guest material into the first organic layer by placing a first liquid composition over a first portion of the first organic layer. The first liquid composition includes at least a first guest material and a first liquid medium. The first liquid composition comes in contact with the first organic layer, and a substantial amount of the first guest material migrates into the first organic layer. The process further includes vapor depositing a second organic layer over at least part of the first organic layer. The second organic layer includes at least one organic material capable of emitting blue light.

In another embodiment, an organic electronic device includes a substrate and a first continuous organic layer overlying the substrate. The first continuous organic layer includes a first portion and a second portion. The organic electronic device also includes a first guest material. A substantial amount of the first guest material lies within the first continuous organic layer. At least part of the first guest material lies within the first portion, and the second portion is substantially free of the first guest material. The organic electronic device further includes a second continuous organic layer overlying the substrate. The second continuous organic layer includes a third portion and a fourth portion. The organic electronic device still further includes a second guest material. A substantial amount of the second guest material lies within the second continuous organic layer. At least part of the second guest material lies within the third portion, and the fourth portion is substantially free of the second guest material.

The foregoing general description and the following detailed description are exemplary and explanatory only and are not restrictive of the invention, as defined in the appended claims.

### BRIEF DESCRIPTION OF THE FIGURES

The invention is illustrated by way of example and not limitation in the accompanying figures.

FIG. 1 includes an illustration of a cross-sectional view of a portion of a substrate, first electrodes, well structures, a charge-transport layer and an organic active layer lying between the well structures. (Prior art)

FIG. 2 includes an illustration of a cross-sectional view of a portion of a substrate including first electrodes and portions of an organic layer.

FIG. 3 includes an illustration of the substrate of FIG. 2 as guest materials are added the organic layer.

FIG. 4 includes an illustration of the substrate of FIG. 3 after the guest materials have migrated into the organic layer.

FIG. 5 includes an illustration of the substrate of FIG. 4 after forming a substantially completed organic device.

FIG. 6 includes an illustration of the substrate of FIG. 2 after three different guest materials have migrated into the organic layer.

FIGs. 7 and 8 include illustrations of the substrate of FIG. 2 using well structures where the liquid compositions are placed over the substrate before forming the organic layer.

FIG. 9 includes an illustration of a cross-sectional view of a portion of a substrate, a filter layer including guest materials, first electrodes, and an organic layer.

FIGs. 10-12 include plots of color coordinates for varying intensities of light.

FIG. 13 illustrates the points from FIGs. 10-12 on a CIE1931 chromaticity chart.

Skilled artisans appreciate that elements in the figures are illustrated for simplicity and clarity and have not necessarily been drawn to scale. For example, the dimensions of some of the elements in the figures may be exaggerated relative to other elements to help to improve understanding of embodiments of the invention.

### DETAILED DESCRIPTION

The present invention provides a process for incorporating at least one guest material into an organic layer. The process includes placing a liquid composition over a portion of the organic layer. The liquid composition includes at least a guest material and a liquid medium. The liquid composition comes in contact with the organic layer, and a substantial amount of the guest material migrates into the organic layer. In another embodiment, the process can be reversed (organic layer formed over the guest material(s). Organic electronic devices may be formed using such processes.

In another aspect, the organic electronic device includes a continuous organic layer overlying a first portion and a second portion of a substrate. A first guest material lies substantially completely within the continuous organic layer. At least part of the first guest material lies within the first portion, and substantially none of the first guest material lies within the second portion of the continuous organic layer. An organic electronic component within the organic electronic device comprises a first electrode, a second electrode, and the first portion of the continuous organic layer but not the second portion of the continuous organic layer. A process for using such an organic electronic device includes biasing the first and second electrodes of the organic electronic component to a first potential difference. The organic electronic component emits radiation at a first emission maximum or responds to radiation at a first wavelength. The process further includes biasing the first and second electrodes of the organic electronic component to a second potential difference that is significantly different from the first potential. The first electronic component emits radiation substantially at the first emission maximum or responds to radiation substantially at the first wavelength.

In a further aspect, a process for forming organic layers includes forming a first organic layer including at least one organic material over a substrate, and incorporating at least one guest material into the first organic layer by placing a first liquid composition over a first portion of the first organic layer. The first liquid composition includes at least a first guest material and a first liquid medium. The first liquid composition comes in contact with the first organic layer, and a substantial amount of the first guest material migrates into the first organic layer. The process further includes vapor depositing a second organic layer over at least part of the first organic layer The second organic layer includes at least one organic material capable of emitting blue light.

Other features and advantages of the invention will be apparent from the following detailed description, and from the claims. The detailed description first addresses Definitions and Clarification of Terms followed by Liquid Compositions, Fabrication Before Introduction of Liquid Composition(s), Introduction of Liquid Composition(s), Remainder of Fabrication, Alternative Embodiments, Electronic Operation of the Organic Electronic Device, Advantages, and finally Examples.

### 1. Definitions and Clarification of Terms

Before addressing details of embodiments described below, some terms are defined or clarified. As used herein, the term "active" when referring to a layer or material is intended to mean a layer or material that exhibits electronic properties, electro-radiative properties, or a combination thereof. An active layer material may emit radiation or exhibit a change in concentration of electron-hole pairs when responding to radiation.

The terms "array," "peripheral circuitry" and "remote circuitry" are intended to mean different areas or components of the organic electronic device. For example, an array may include a number of pixels, cells, or other structures within an orderly arrangement (usually designated by columns and rows). The pixels, cells, or other structures within the array may be controlled locally by peripheral circuitry, which may lie within the same organic electronic device as the array but outside the array itself. Remote circuitry typically lies away from the peripheral circuitry and can send signals to or receive signals from the array (typically via the peripheral circuitry). The remote circuitry may also perform functions unrelated to the array. The remote circuitry may or may not reside on the substrate having the array.

The term "continuous" when referring to a layer is intended to mean a layer that covers an entire substrate or portion of a substrate (e.g., the array) without any breaks in the layer. Note that a continuous layer may have a portion that is locally thinner than another portion and still be continuous if there is no break or gap in the layer.

The term "emission maximum" is intended to mean the highest intensity of radiation emitted. The emission maximum has a corresponding wavelength or spectrum of wavelengths (e.g. red light, green light, or blue light).

The term "filter," when referring to a layer material, is intended to mean a layer or material separate from a radiation-emitting or radiation-sensing layer, wherein the filter is used to limit the wavelength(s) of radiation passing through such layer or material. For example, a red filter layer may allow substantially only red light from the visible light spectrum to pass through the red filter layer. Therefore, the red filter layer filters out green light and blue light.

The term "guest material" is intended to mean a material, within a layer including a host material, that changes the electronic characteristic(s) or the targeted wavelength of radiation emission, reception, or filtering of the layer compared to the electronic characteristic(s) or the wavelength of radiation emission, reception, or filtering of the layer in the absence of such material.

The term "host material" is intended to mean a material, usually in the form of a layer, to which a guest material may be added. The host material may or may not have electronic characteristic(s) or the ability to emit, receive, or filter radiation.

The term "maximum operating potential difference" is intended to mean the greatest difference in potential between electrodes of a radiation-emitting component during normal operation of such radiation-emitting component.

The term "migrate" and its variants are intended to be broadly construed as movement into or within a layer or material without the use of an external electrical field, and covers dissolution, diffusion, emulsifying and suspending (for a suspension). Migrate does not cover ion implantation.

The term "organic electronic device" is intended to mean a device including one or more organic active layers or materials. Organic electronic devices include: (1) devices that convert electrical energy into radiation (e.g., a light-emitting diode, light emitting diode display, flat panel light, or diode laser), (2) devices that generate signals based at least in part in response to environmental conditions and may or may not include electronics used for detection or to perform other logic operations (e.g., photodetectors (e.g., photoconductive cells, photoresistors, photoswitches, phototransistors, phototubes), IR detectors, biosensors), (3) devices that convert radiation into electrical energy (e.g., a photovoltaic device or solar cell), and (4) devices that include one or more electronic components that include one or more organic active layers (e.g., a transistor or diode).

The term "precision deposition technique" is intended to mean a deposition technique that is capable of depositing one or more materials over a substrate at a dimension, as seen from a plan of the substrate, no greater than approximately one millimeter. A stencil mask, frame, well structure, patterned layer or other structure(s) may be present during such deposition.

The term "primary surface" refers to a surface of a substrate from which electronic components are fabricated.

The phrase "room temperature" is intended to mean a temperature in a range of approximately 20-25°C.

The term "substantial amount" is intended to mean, on a mass basis, at least one third of an original amount. For example, when a substantial amount of a guest material lies within an organic layer, at least one third of the guest material in a drop (original amount of guest material) that is placed over the organic layer lies within that organic layer.

The term "substantially completely" is intended to mean a material, layer, or structure, lies completely within a different layer or different structure with the possible exception of an insignificant amount, on a volume basis, of such material, layer, or structure.

The term "substantially free," when referring to a specific material, is intended to mean that a trace amount of the specific material is present, but not in a quantity that significantly affects the electrical or radiative (emission, reception, transmission, or any combination thereof) properties of a different material in which the specific material resides.

The term "substantially liquid" when referring to a layer, material, or composition is intended to mean that a layer or material is in the form of a liquid, solution, dispersion, emulsion, or suspension. A substantially liquid material can include one or more liquid media and is capable of significantly flowing if not properly retained.

The term "substantially solid" when referring to a layer or material is intended to mean that a layer or material, which if overlying a substrate, does not significantly flow when the substrate is placed on its side (primary surface of substrate oriented substantially perpendicular to the ground) for at least one hour at room temperature.

The term "well structure" refers to a structure used to confine a liquid during processing. A well structure may also be called a dam, dividers, or a frame.

As used herein, the terms "comprises," "comprising," "includes," "including," "has," "having" or any other variation thereof, are intended to cover a non-exclusive inclusion. For example, a process, method, article, or apparatus that comprises a list of elements is not necessarily limited to only those elements but may include other elements not expressly listed or inherent to such process, method, article, or apparatus. Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present). Also, use of the "a" or "an" are employed to describe elements and components of the invention. This is done merely for convenience and to give a general sense of the invention. This description should be read to include one or at least one and the singular also includes the plural unless it is obvious that it is meant otherwise.

Group numbers corresponding to columns within the periodic table of the elements use the "New Notation" convention as seen in the CRC *Handbook of Chemistry and Physics,* 81^{st} Edition (2000).

Unless otherwise defined, all technical and scientific terms used herein have the same meaning as commonly understood by one of ordinary skill in the art to which this invention belongs. Although methods and materials similar or equivalent to those described herein can be used in the practice or testing of the present invention, suitable methods and materials are described below. All publications, patent applications, patents, and other references mentioned herein are incorporated by reference in their entirety. In case of conflict, the present specification, including definitions, will control. In addition, the materials, methods, and examples are illustrative only and not intended to be limiting.

To the extent not described herein, many details regarding specific materials, processing acts, and circuits are conventional and may be found in textbooks and other sources within the organic light-emitting diode display, photodetector, photovoltaic, and semiconductor arts.

### 2. Liquid Compositions

The concepts as taught in this specification can be applied to organic electronic devices to form one or more layers in which a substantial amount of one or more guest materials is incorporated at least partially within an organic layer, which comprises at least one host material. In one embodiment, a substantial amount is at least approximately 40 percent, and in another embodiment, is at least approximately 50 percent. In still a further embodiment, substantially all of the one or more guest materials may be incorporated. Well structures may or may not be present during the incorporation process. More specifically, one or more liquid compositions, including the one or more guest materials and a liquid medium, may be in the form of a solution, dispersion, emulsion, or suspension.

This paragraph includes a description of one interaction between the organic layer and the liquid composition. Note that the organic layer can be a layer overlying a substrate. Alternatively, the substrate may not be present or the organic layer is the substrate. Although the description in this paragraph refers to a liquid composition having one guest material to simplify understanding, more than one guest material may be used, and the principles for a dispersion emulsion, or suspension are similar. Alternatively, the liquid composition may also include a host material, which is also present in the organic layer, in addition to one or more guest materials. The liquid composition may be placed over the precise area where the guest material is to migrate into the organic layer. The liquid medium of the liquid composition is capable of forming a solution, dispersion, emulsion, or suspension with the organic layer to convert the organic layer from a substantially solid state to a substantially liquid state in the form of such solution, dispersion, emulsion, or suspension. The organic layer has good miscibility characteristics with the liquid medium used for the liquid composition. As the liquid medium converts a localized region of the organic layer to a substantially liquid state, the guest material can migrate into the organic layer. Unexpectedly, most of the guest material migrates into the organic layer. In one embodiment, substantially all of the guest material from the liquid composition migrates into the organic layer. The guest material effects the radiation emitted from, responded to by, transmitted through, or electronic characteristics of the organic layer.

The host material(s) for forming the organic layer vary based upon the application of the organic electronic device and the use of the organic layer within the organic electronic device. At least portion(s) of the organic layer may be used as a radiation-emitting organic active layer, a radiation-responsive organic active layer, a filter layer, or layer within an electronic component (e.g., at least part of a resistor, transistor, capacitor, etc.).

For a radiation-emitting organic active layer, suitable radiation-emitting host materials include one or more small molecule materials, one or more polymeric materials; or a combination thereof. Small molecule materials may include those described in, for example, U. S. Patent 4,356,429 ("Tang"); U. S. Patent 4,539,507 ("Van Slyke"); U.S. Patent Application Publication No. US 2002/0121638 ("Grushin"); and U. S. Patent 6,459,199 ("Kido"). Alternatively, polymeric materials may include those described in U. S. Patent 5,247,190 ("Friend"); U. S. Patent 5,408,109 ("Heeger"); and U. S. Patent 5,317,169 ("Nakano"). Exemplary materials are semiconducting conjugated polymers. Examples of such polymers include poly(paraphenylenevinylene) (PPV), PPV copolymers, polyfluorenes, polyphenylenes, polyacetylenes, polyalkylthiophenes, poly(n-vinylcarbazole) (PVK), and the like. In one specific embodiment, a radiation-emitting active layer without any guest materials may emit blue light.

For a radiation-responsive organic active layer, suitable radiation-responsive host materials may include many conjugated polymers and electroluminescent materials. Such materials include for example, many conjugated polymers and electro- and photo-luminescent materials. Specific examples include poly(2-methoxy,5-(2-ethyl-hexyloxy)-1,4-phenylene vinylene) ("MEH-PPV") and MEH-PPV composites with CN-PPV.

The location of a filter layer may be between an organic active layer and a user side of the organic electronic device. A filter layer may be part of a substrate, an electrode (e.g., an anode or a cathode), a charge-transport layer; lie between any one or more of the substrate, electrodes, charge-transport layer; or any combination thereof. In another embodiment, the filter layer may be a layer that is fabricated separately (while not attached to the substrate) and later attached to the substrate at any time before, during, or after fabricating the electronic components within the organic electronic device. In this embodiment, the filter layer may lie between the substrate and a user of the organic electronic device.

When the filter layer is separate from or part of the substrate or lies between the substrate and an electrode closest to the substrate, suitable host materials includes many different organic materials including polyolefins (e.g., polyethylene or polypropylene); polyesters (e.g., polyethylene terephthalate or polyethylene naphthalate); polyimides; polyamides; polyacrylonitriles and polymethacrylonitriles; perfluorinated and partially fluorinated polymers (e.g., polytetrafluoroethylene or copolymers of tetrafluoroethylene and polystyrenes); polycarbonates; polyvinyl chlorides; polyurethanes; polyacrylic resins, including homopolymers and copolymers of esters of acrylic or methacrylic acids; epoxy resins; Novolac resins; and combinations thereof.

When the filter layer is part of the hole-transport layer, suitable host materials include polyaniline ("PANI"), poly(3,4-ethylenedioxythiophene) ("PEDOT"), organic charge transfer compounds, such as tetrathiafulvalene tetracyanoquinodimethane (TTF-TCQN), hole-transport materials as described in Kido, and combinations thereof.

When the filter layer is part of the electron-transport layer, suitable host materials include metal-chelated oxinoid compounds (e.g., Alq₃); phenanthroline-based compounds (e.g., 2,9-dimethyl-4,7-dipheny)-1,10-phenanthroline ("DDPA"), 4,7-diphenyl-1,10-phenanthroline ("DPA")); azole compounds (e.g., 2-(4-biphenyl)-5-(4-t-butylphenyl)-1,3,4-oxadiazole ("PBD"), 3-(4-biphenyl)-4-phenyl-5-(4-t-butylphenyl)-1,2,4-triazole ("TAZ"); electron-transport materials as described in Kido; and combinations thereof.

For an electronic components, such as a resistor, transistor, capacitor, etc., the organic layer may include one or more of thiophenes (e.g., polythiophene, poly(alkylthiophene), alkylthiophene, bis(dithienthiophene), alkylanthradithiophene, etc.), polyacetylene, pentacene, phthalocyanine, and combinations thereof.

Guest materials can include any one or more of all known materials used for an electroluminescent layer, charge transport (e.g., hole transport, electron transport) layer, or other materials used for organic active layer and their corresponding dopants. Such guest materials can include organic dyes, organometallic materials, polymers (conjugated, partially conjugated, or non-conjugated), and combinations thereof. The guest materials may or may not have fluorescent or phosphorescent properties.

Examples of the organic dyes include 4-dicyanmethylene-2-methyl-6-(p-dimethyaminostyryl)-4H-pyran (DCM), coumarin, pyrene, perylene, rubrene, derivatives thereof, and combinations thereof.

Examples of organometallic materials include functionalized polymers comprising functional groups coordinated to at least one metal. Exemplary functional groups contemplated for use include carboxylic acids, carboxylic acid salts, sulfonic acid groups, sulfonic acid salts, groups having an OH moiety, amines, imines, diimines, N-oxides, phosphines, phosphine oxides, β-dicarbonyl groups, and combinations thereof. Exemplary metals contemplated for use include lanthanide metals (e.g., Eu, Tb), Group 7 metals (e.g., Re), Group 8 metals (e.g., Ru, Os), Group 9 metals (e.g., Rh, Ir), Group 10 metals (e.g., Pd, Pt), Group 11 metals (e.g., Au), Group 12 metals (e.g., Zn), Group 13 metals (e.g., Al), and combinations thereof. Such organometallic materials include metal chelated oxinoid compounds, such as tris(8-hydroxyquinolato)aluminum (Alq₃); cyclometalated iridium and platinum electroluminescent compounds, such as complexes of iridium with phenylpyridine, phenylquinoline, or phenylpyrimidine ligands as disclosed in Published PCT Application WO 02/02714, and organometallic complexes described in, for example, published applications US 2001/0019782, EP 1191612, WO 02/15645, WO 02/31896, and EP 1191614; and mixtures thereof.

Examples of conjugated polymers include poly(phenylenevinylenes), polyfluorenes, poly(spirobifluorenes), copolymers thereof, and mixtures thereof.

When used for the production of full color organic electronic devices, in one embodiment, a first guest material is selected to emit red light (with an emission maximum in a range of 600-700 nm) and a second guest material is selected to emit green light (with an emission maximum in a range of 500-600 nm). After placement of each of the liquid compositions, each pixel column contains three subpixels wherein one subpixel emits red light, one subpixel emits green light, and one subpixel emits blue light (with an emission maximum in a range of 400-500 nm). Alternatively, one or more guest materials can be contained in a single liquid composition and deposited to form a pixel or subpixel with a broader emission spectrum, for example with a Full Width Half Maximum (FWHM) of greater than 100 nm, or even selected to emit white light with an emission profile encompassing the visible spectrum of 400 to 700 nm.

One or more liquid media may be used in the liquid compositions. Liquid media contemplated for use in the practice of the invention are chosen so as to provide proper solution characteristics for both the guest material and the organic layer that receives the guest material. Factors to be considered when choosing a liquid media include, for example, viscosity of the resulting solution, emulsion, suspension, or dispersion, molecular weight of a polymeric material, solids loading, type of liquid medium, vapor pressure of the liquid medium, temperature of an underlying substrate, thickness of an organic layer that receives a guest material, or any combination thereof.

When selecting a liquid medium, a particular liquid medium may form a solution, emulsion, suspension, or dispersion with one type of organic layer but not necessarily form a solution, emulsion, suspension, or dispersion with another type of organic layer. For example, a particular liquid medium may form a solution, emulsion, suspension, or dispersion with the organic active layer 250 but not with the charge transport layer 240. The liquid medium (media) has a vapor pressure low enough so that is will not evaporate prior the desired level of migration for the guest material(s) or host material(s) into the organic active layer 250.

In some embodiments, the liquid medium (media) includes at least one organic solvent. Exemplary organic solvents include halogenated solvents, hydrocarbon solvents, aromatic hydrocarbon solvents, ether solvents, cyclic ether solvents, alcohol solvents, ketone solvents, nitrile solvents, sulfoxide solvents, amide solvents, and combinations thereof.

Exemplary halogenated solvents include carbon tetrachloride, methylene chloride, chloroform, tetrachloroethylene, chlorobenzene, bis(2-chloroethyl)ether, chloromethyl ethyl ether, chloromethyl methyl ether, 2-chloroethyl ethyl ether, 2-chloroethyl propyl ether, 2-chloroethyl methyl ether, and combinations thereof.

Exemplary hydrocarbon solvents include pentane, hexane, cyclohexane, heptane, octane, decahydronaphthalene, petroleum ethers, ligroine, and combinations thereof.

Exemplary aromatic hydrocarbon solvents include benzene, naphthalene, toluene, xylene, ethyl benzene, cumene (iso-propyl benzene) mesitylene (trimethyl benzene), ethyl toluene, butyl benzene, cymene (iso-propyl toluene), diethylbenzene, iso-butyl benzene, tetramethyl benzene, sec-butyl benzene, tert-butyl benzene, and combinations thereof.

Exemplary ether solvents include diethyl ether, ethyl propyl ether, dipropyl ether, disopropyl ether, dibutyl ether, methyl t-butyl ether, glyme, diglyme, benzyl methyl ether, isochroman, 2-phenylethyl methyl ether, n-butyl ethyl ether, 1,2-diethoxyethane, sec-butyl ether, diisobutyl ether, ethyl n-propyl ether, ethyl isopropyl ether, n-hexyl methyl ether, n-butyl methyl ether, methyl n-propyl ether, and combinations thereof.

Exemplary cyclic ether solvents suitable include tetrahydrofuran, dioxane, tetrahydropyran, 4 methyl-1,3-dioxane, 4-phenyl-1,3-dioxane, 1,3-dioxolane, 2-methyl-1,3-dioxolane, 1,4-dioxane, 1,3-dioxane, 2,5-dimethoxytetrahydrofuran, 2,5-dimethoxy-2,5-dihydrofuran, and combinations thereof.

Exemplary alcohol solvents include methanol, ethanol, 1-propanol, 2-propanol, 1-butanol, 2-butanol, 2-methyl-1-propanol (i.e., iso-butanol), 2-methyl-2-propanol (i.e., tert-butanol), 1-pentanol, 2-pentanol, 3-pentanol, 2,2-dimethyl-1-propanol, 1-hexanol, cyclopentanol, 3-methyl-1-butanol, 3-methyl-2-butanol, 2-methyl-1-butanol, 2,2-dimethyl-1-propanol, 3-hexanol, 2-hexanol, 4-methyl-2-pentanol, 2-methyl-1-pentanol, 2-ethylbutanol, 2,4-dimethyl-3-pentanol, 3-heptanol, 4-heptanol, 2-heptanol, 1-heptanol, 2-ethyl-1-hexanol, 2,6-dimethyl-4-heptanol, 2-methylcyclohexanol, 3-methylcyclohexanol, 4-methylcyclohexanol, and combinations thereof.

Alcohol ether solvents may also be employed. Exemplary alcohol ether solvents include 1-methoxy-2-propanol, 2-methoxyethanol, 2-ethoxyethanol, 1-methoxy-2-butanol, ethylene glycol monoisopropyl ether, 1-ethoxy-2-propanol, 3-methoxy-1-butanol, ethylene glycol monoisobutyl ether, ethylene glycol mono-n-butyl ether, 3-methoxy-3-methylbutanol, ethylene glycol mono-tert-butyl ether, and combinations thereof.

Exemplary ketone solvents include acetone, methylethyl ketone, methyl iso-butyl ketone, cyclohexanone, isopropyl methyl ketone, 2-pentanone, 3-pentanone, 3-hexanone, diisopropyl ketone, 2-hexanone, cyclopentanone, 4-heptanone, iso-amyl methyl ketone, 3-heptanone, 2-heptanone, 4-methoxy-4-methyl-2-pentanone, 5-methyl-3-heptanone, 2-methylcyclohexanone, diisobutyl ketone, 5-methyl-2-octanone, 3-methylcyclohexanone, 2-cyclohexen-1-one, 4-methylcyclohexanone, cycloheptanone, 4-tert-butylcyclohexanone, isophorone, benzyl acetone, and combinations thereof.

Exemplary nitrile solvents include acetonitrile, acrylonitrile, trichloroacetonitrile, propionitrile, pivalonitrile, isobutyronitrile, n-butyronitrile, methoxyacetonitrile, 2-methylbutyronitrile, isovaleronitrile, N-valeronitrile, n-capronitrile, 3-methoxypropionitrile, 3-ethoxypropionitrile, 3,3'-oxydipropionitrile, n-heptanenitrile, glycolonitrile, benzonitrile, ethylene cyanohydrin, succinonitrile, acetone cyanohydrin, 3-n-butoxypropionitrile, and combinations thereof.

Exemplary sulfoxide solvents suitable include dimethyl sulfoxide, din-butyl sulfoxide, tetramethylene sulfoxide, methyl phenyl sulfoxide, and combinations thereof.

Exemplary amide solvents suitable include dimethyl formamide, dimethyl acetamide, acylamide, 2-acetamidoethanol, N,N-dimethyl-m-toluamide, trifluoroacetamide, N,N-dimethylacetamide, N,N-diethyldodecanamide, epsilon-caprolactam, N,N-diethylacetamide, N-tert-butylformamide, formamide, pivalamide, N-butyramide, N,N-dimethylacetoacetamide, N-methyl formamide, N,N-diethylformamide, N-formylethylamine, acetamide, N,N-diisopropylformamide, 1-formylpiperidine, N-methylformanilide, and combinations thereof.

Crown ethers contemplated include all crown ethers which can function to assist in the reduction of the chloride content of an epoxy compound starting material as part of the combination being treated according to the invention. Exemplary crown ethers include benzo-15-crown-5; benzo-18-crown-6; 12-crown-4; 15-crown-5; 18-crown-6; cyclohexano-15-crown-5; 4',4"(5")-ditert-butyldibenzo-18-crown-6; 4',4"(5")-ditert-butyldicyclohexano-18-crown-6; dicyclohexano-18-crown-6; dicyclohexano-24-crown-8; 4'-aminobenzo-15-crown-5; 4'-aminobenzo-18-crown-6; 2-(aminomethyl)-15-crown-5; 2-(aminomethyl)-18-crown-6; 4'-amino-5'-nitrobenzo-15-crown-5; 1-aza-12-crown-4; 1-aza-15-crown-5; 1-aza-18-crown-6; benzo-12-crown-4; benzo-15-crown-5; benzo-18-crown-6; bis((benzo-15-crown-5)-15-ylmethyl)pimelate; 4-bromobenzo-18-crown-6; (+)-(18-crown-6)-2,3,11,12-tetra-carboxylic acid; dibenzo-18-crown-6; dibenzo-24-crown-8; dibenzo-30-crown-10; ar-ar'-di-tert-butyldibenzo-18-crown-6; 4'-formylbenzo-15-crown-5; 2-(hydroxymethyl)-12-crown-4; 2-(hydroxymethyl)-15-crown-5; 2-(hydroxymethyl)-18-crown-6; 4'-nitrobenzo-15-crown-5; poly-[(dibenzo-18-crown-6)-co-formaldehyde]; 1,1-dimethylsila-11-crown-4; 1,1-dimethylsila-14-crown-5; 1,1-dimethylsila-17-crown-5; cyclam; 1,4,10,13-tetrathia-7,16-diazacyclooctadecane; porphines; and combinations thereof.

In another embodiment, the liquid medium includes water. A conductive polymer complexed with a water-insoluble colloid-forming polymeric acid can be deposited over a substrate and used as a charge transport layer.

Many different classes of liquid media (e.g., halogenated solvents, hydrocarbon solvents, aromatic hydrocarbon solvents, water, etc.) are described above. Mixtures of more than one of the liquid media from different classes may also be used.

### 3. Fabrication Before Introduction of Liquid Composition(s)

Attention is now directed to details in an exemplary embodiment that is described and illustrated in FIGs. 2-5. Referring to FIG. 2, first electrodes 220 are formed over portions of the substrate 200. The substrate 200 may be a conventional substrate as used in the organic electronic device arts. Substrate 200 can be flexible or rigid, organic or inorganic. Generally, glass or flexible organic films are used. Pixel driver and other circuits may be formed within or over the substrate 200 using conventional techniques. The other circuits (not shown) outside the array may include peripheral and remote circuitry used to control the pixels within the array. The focus of fabrication is on the pixel array rather than the peripheral or remote circuitry. The substrate 200 can have a thickness in a range of approximately 12-2500 microns.

The first electrodes 220 act as anodes and may include one or more conductive layers. The surface of the first electrodes 220 furthest from the substrate 200 includes a high work function material. In this illustrative example, the first electrodes 220 include one or more of layers of indium tin oxide, aluminum tin oxide, or other materials conventionally used for anodes within organic electronic devices. In this embodiment, the first electrodes 220 transmit at least 70% of the radiation to be emitted from or responded to by subsequently formed organic active layer(s). In one embodiment, the thickness of the first electrodes 220 is in a range of approximately 100-200 nm. If radiation does not need to be transmitted through the first electrodes 220, the thickness may be greater, such as up to 1000 nm or even thicker.

The first electrodes 220 may be formed using one or more of any number of different techniques including a conventional coating, casting, vapor deposition (chemical or physical), printing (ink jet printing, screen printing, solution dispense, or any combination thereof), other deposition technique, or any combination thereof. In one embodiment, the first electrodes 220 may be formed as a patterned layer (e.g., using a stencil mask) or by depositing the layer(s) over all the substrate 200 and using a conventional patterning technique.

An organic layer 230 may be formed over the first electrodes 220 as shown in FIG. 2. The organic layer 230 may include one or more layers. For example, the organic layer 230 may include a charge transport layer 240 and organic active layer 250, charge transport layers may lie along both sides of the organic active layer 250, the charge transport layer may overlie rather than underlie the organic active layer 250, or the organic active layer 250 may be used without the charge transport layer 240. When the charge transport layer 240 lies between the first electrodes 220 and the organic active layer 250, the charge transport layer 240 will be a hole-transport layer, and when the charge transport layer lies between the organic active layer 250 and subsequently formed second electrode(s) that act as cathodes, the charge transport layer (not shown in FIG. 2) will be an electron-transport layer. The embodiment as shown in FIG. 2 has the charge transport layer 240 that acts as the hole-transport layer.

The charge transport layer 240 and the organic active layer 250 are formed sequentially over the first electrodes 220. In addition to facilitating transport of charge from the first electrodes 220 to the organic active layer 250, the charge transport layer 240 may also function as a charge injection layer facilitating injection of charged carriers into the organic active layer 250, a planarization layer over the first electrodes 220, a passivation or chemical barrier layer between the first electrodes 220 and the organic active layer 250, or any combination thereof. Each of the charge transport layer 240 and the organic active layer 250 can be formed by one or more of any number of different techniques including spin coating, casting, vapor depositing (chemical or physical), printing (ink jet printing, screen printing, solution dispensing, or any combination thereof), other depositing or any combination thereof for appropriate materials as described below. One or both of the charge transport layer 240 and the organic active layer 250 may be cured after deposition.

When the charge transport layer 240 acts as a hole-transport layer, any number of materials may be used (and its selection will depend on the device and the organic active layer 250 material) and in this illustrative example, it may include one or more of polyaniline ("PANI"), poly(3,4-ethylenedioxythiophene) ("PEDOT") or material(s) conventionally used as hole-transport layers as used in organic electronic devices. The hole-transport layer typically has a thickness in a range of approximately 100-250 nm as measured over the substrate 200 at a location spaced apart from the first electrodes 220.

The composition of the organic active layers 250 typically depends upon the application of the organic electronic device. In the embodiment shown in FIG. 2, the organic active layer 250 is used in radiation-emitting components. The organic active layer 250 can include material(s) as conventionally used as organic active layers in organic electronic devices and can include one or more small molecule materials, one or more polymer materials, or any combination thereof. After reading this specification, skilled artisans will be capable of selecting appropriate material(s), layer(s) or both for the organic active layer 250.

As formed, the organic layer 230 (including charge transport layer 240 and organic active layer 250) are substantially continuous over an array of organic electronic components to be formed. In one embodiment, the organic layer 230 may be substantially continuous over the entire substrate, including the peripheral and remote circuitry areas. Note that the organic layer 230 has regions where the organic layer 230 is locally thinner, but it is not discontinuous over the area of the substrate 200 in which the organic layer 230 is intended to be formed (e.g., the array). Referring to FIG. 2, the organic layer 230, including one or both of the charge transport layer 240 and the organic active layer 250, is locally thinner over the first electrodes 220 and locally thicker away from the first electrodes 220. The organic layer 230 typically has a thickness in a range of approximately 50-500 nm as measured over the substrate 200 at a location spaced apart from the first electrodes 220.

If the organic electronic device is a radiation-emitting microcavity device, care must be taken in choosing the thickness of the organic layer 230 so that the desired spectrum of emission wavelengths is obtained.

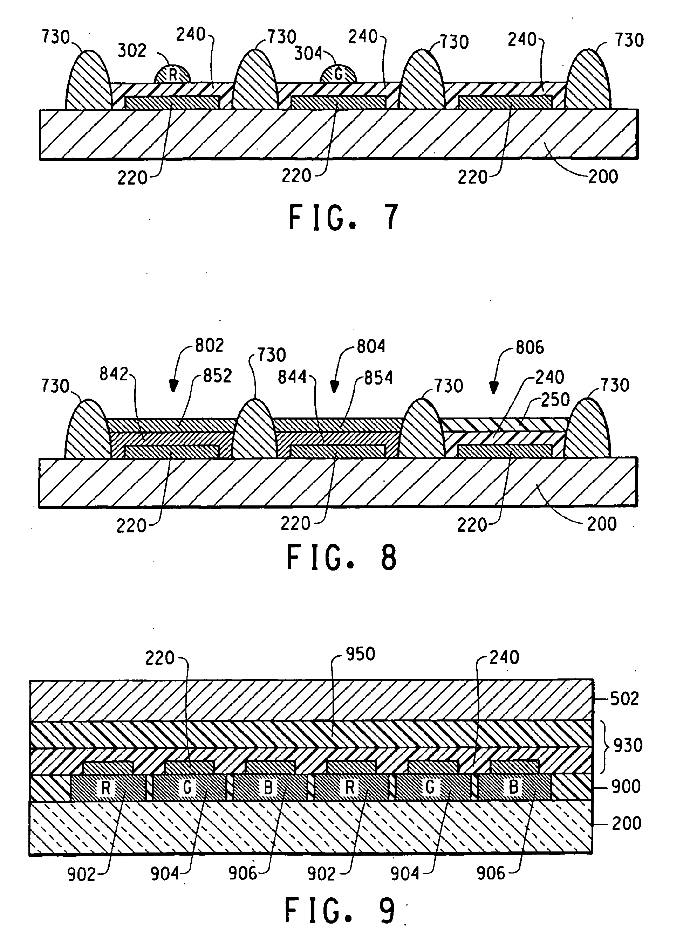

In another embodiment, well structures could be formed similar to the well structures 130 as shown in FIG. 1. In this embodiment, the organic layer 230 may be formed over the substrate 200 and the well structures. Note that the organic layer 230 may be locally thinner along the sides near the top of the well structures; however, the organic layer 230 has no discontinuity over the well structures between the first electrodes 220. FIGs. 7 and 8, which are described later, include still another embodiment that can use well structures.

In an alternative embodiment, the organic layer 230 may include a single layer with a composition that varies with thickness. For example, the composition nearest the first electrodes 220 may act as a hole transporter, the next composition may act as an organic active layer, and the composition furthest from the first electrodes 220 may act as an electron transporter. One or more materials may be present throughout all or only part of the thickness of the organic layer.

### 4. Introduction of Liquid Composition(s)

One or more liquid compositions (illustrated as circles 302 and 304) may be placed over portions of the organic layer 230 as shown in FIG. 3. In one embodiment, the organic active layer 250 includes a host material that can emit blue light, liquid composition 302 may include a red guest material, and liquid composition 304 may include a green guest material. Before the placement, the organic layer 230 may or may not be substantially solid. The liquid compositions 302 and 304 may be placed over the organic layer 230 using a precision deposition technique. A stencil mask, frame, well structure, patterned layer or other structure(s) may be present during such deposition. Non-limiting examples of the precision deposition technique include screen printing, ink jet printing, solution dispense (dispensing the liquid composition in strips or other predetermined geometric shapes or patterns, as seen from a plan view), needle aspiration, vapor deposition using stencil (shadow) masks, selective chemical vapor deposition, selective plating, and combinations thereof. The liquid compositions 302 and 304 may be placed over the organic layer 230 sequentially or simultaneously. For simplicity, each of the liquid compositions 302 and 304 in FIG. 2 are referred to as "drops," whether or not the liquid compositions 302 and 304 are introduced as drops. A number of parameters can be varied that affect the initial area of the organic layer 230 affected by the liquid compositions 302 and 304. For example, such parameters are selected from a group consisting of drop volume, spacing between organic electronic components, drop viscosity, and any combination thereof.

The one or more liquid media from the liquid compositions 302 and 304 can come in contact with and convert the organic layer 230 from a substantially solid state to a substantially liquid state. As the liquid medium (media) from each drop contacts the organic layer 230, the liquid medium (media) can dissolve part or all of a thickness of the organic layer 230 to form a solution, disperse part or all of a thickness of the organic layer 230 to form a dispersion, form an emulsion, or suspend part or all of a thickness of the organic layer 230 to form a suspension. Note that as more of the liquid medium (media) interacts with the organic layer 230, the viscosity of the "mixture" of liquid composition and organic layer 230 increases. The increased viscosity effectively inhibits lateral movement (movement substantially parallel to the primary surface of the substrate 200) of the drops. In one embodiment, the migration of the guest material(s) into the organic layer 230 may be performed at a temperature no greater than 40°C, and in another embodiment, may be performed at substantially room temperature.

The volume selected for the drop may be affected by the thickness of the organic layer 230 or portion thereof, by the host material within the organic layer 230, or a combination thereof. In one embodiment, the guest material from the drop only needs to migrate into the organic active layer 250. If the drop volume is too small, not all of the thickness of the organic active layer 250 may be affected. Also, if the guest material concentration within the organic active layer 250 is too low, the targeted luminance efficiency might not be achieved. During operation, the emission or responsive spectrum radiation for of the organic active layer 250 may be significantly affected by the potential (voltage) difference between the first and second electrodes. If the drop volume is too large, undesired lateral spreading of the liquid composition may occur, and the guest material may reach a neighboring region where guest material within such region is undesired. For example, if the volume of a red-doped drop is too large, it may enter a region that is to have green or blue emission. If such happens, the neighboring region may emit red. Therefore, a ratio of volume of liquid composition to thickness of the organic layer 230 may be used.

The use of well structures may reduce the likelihood of lateral migration, however, the volume of the liquid composition should not be so much as to overflow the "levee" formed by the well structures, such that the liquid composition could migrate into an adjacent well.

After the liquid compositions 302 and 304 are placed over the organic layer 230 and a substantial amount (addressed later in this specification) of the guest material(s) within the liquid compositions 302 and 304 migrate into the organic active layer 250, the liquid medium (media) of the liquid compositions 302 and 304 is evaporated to give the organic layer 230 with doped regions 402 and 404. In this embodiment, region 402 is designed to emit red light, and region 404 is designed to emit green light. The evaporation may be performed at a temperature in a range of approximately 20-240°C for a time in a range of approximately 5 seconds to 5 minutes. In one embodiment, the evaporation may be performed at a temperature in a range of approximately 30-50°C for a time in a range of approximately 0.5-1.5 minutes. The evaporation may be performed using an oven or a hot plate. The evaporation may be performed at a variety of pressures. In one embodiment, the evaporation may be performed at substantially atmospheric pressure. In another embodiment, a vacuum pressure (significantly lower than atmospheric pressure) may be used. If a vacuum is used, care should be taken to avoid generating permanent bubbles within the organic layer 230 or spewing material to adjacent areas if boiling occurs.

After evaporation, the organic layer 230, including regions 402 and 404, is substantially solid. The process can be used to introduce a substantial amount of guest material(s) into the organic layer 230. On a mass basis, at least a third of one or both of the guest materials that were in drops 302 and 304, before being placed over the organic layer, migrates into the organic layer 230 at regions 402 and 404. In other embodiments, at least approximately 40 percent, 50 percent, or substantially all of the guest material that was in the drops 302 and 304 lie within the organic layer 230.

If the guest materials are introduced into the organic active layer 250 by repeatedly placing liquid compositions 302 and 304 over the organic layer 230, it may not be necessary to fully evaporate the liquid media between successive depositions of the liquid compositions.

If the organic active layer 250 comprises host material(s) that are to be cross-linked, the organic active layer 250 may be formed by one or more of any number of different techniques including spin coating, casting, vapor deposition (chemical or physical), printing ((ink jet printing, screen printing, solution dispense, or any combination thereof), other deposition technique, or any combination thereof. A heating step may be used to evaporate the liquid medium (media) used during the deposition step, if any, to make the organic active layer 250 substantially solid. However, the temperature or other conditions should not be so aggressive such that cross-linking occurs. The liquid composition(s) can be placed over and come in contact with the organic active layer 250, and guest material(s) within the composition(s) can migrate into the organic active layer 250. The liquid medium (media) for the liquid compositions can be evaporated, and the organic active layer 250 may be subjected to the conditions sufficient to achieve the cross-linking. Actual temperatures and pressure used may depend on the materials used for cross-linking.

The liquid medium (media) helps to "pull" the guest material into the organic layer 230 as a solution, dispersion, emulsion, or suspension that is formed by a combination of the liquid medium (media) and organic layer 230. Therefore, a substantial amount of the guest material(s) within the liquid composition(s) may migrate toward the first electrodes 220 without substantial lateral migration or diffusion. The concentration of the guest material(s) near the surface of the organic layer 230 (over which the second electrode(s) is (are) subsequently formed) can be less than an order of magnitude different from the concentration of the guest material(s) near the opposite surface (near the first electrodes 220). The concentrations of the guest material(s) near the opposite sides of the organic active layer 250 are closer to each other. A thermal drive step is not required. The concentration gradient between the first electrodes 220 and a subsequently formed second electrode (concentration gradient measured in a direction perpendicular to the primary surface of the substrate) is lower a concentration gradient formed by a conventional thermal diffusion process. The emission spectra from an organic electronic device formed by such a technique may not be significantly affected by changing the potential difference between the first and second electrodes.

### 5. Remainder of Fabrication

Although not shown, an optional charge transport layer that acts as an electron-transport layer may be formed over the organic active layer 250. The optional charge transport layer may include at least one of aluminum tris(8-hydroxyquinoline) or other material conventionally used as electron-transport layers in organic electronic devices. The optional charge transport layer can be formed by one or more of any number of different techniques including spin coating, casting, vapor deposition (chemical or physical), printing (ink jet printing, screen printing, solution dispense, or any combination thereof), other depositing technique, or any combination for appropriate materials as described below. The electron-transport layer typically has a thickness in a range of approximately 30-500 nm as measured over the substrate 200 at a location spaced apart from the first electrodes 220.

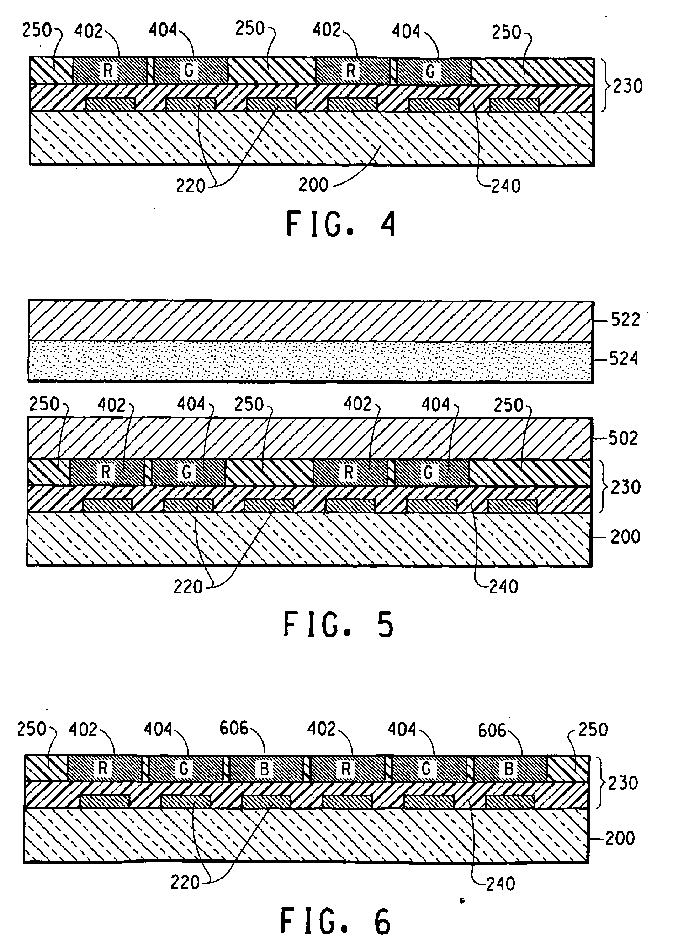

A second electrode 502 is formed over the organic layer 230 including charge transport layer 240 and the organic active layer 250 as shown in FIG. 5. In this specific embodiment, the second electrode 502 acts as a common cathode for an array. The surface of the second electrode 502 includes a low work function material. The second electrode 502 includes one or more of a Group 1 metal, Group 2 metal, or other materials conventionally used for cathodes within organic electronic devices.

The second electrode 502 may be formed using one or more of any number of different techniques including a conventional coating, casting, vapor deposition (chemical or physical), printing (ink jet printing, screen printing, solution dispense, or any combination thereof), or other deposition technique, or any combination thereof. The second electrode 502 may be formed as a patterned layer (e.g., using a shadow mask) or by depositing the layer(s) over the entire array and using a conventional patterning sequence. The second electrode 502 has a thickness in a range of approximately 100-2000 nm.

Other circuitry not illustrated in FIG. 5 may be formed using any number of the previously described or additional layers. Although not shown, additional insulating layer(s) and interconnect level(s) may be formed to allow for circuitry in peripheral areas (not shown) that may lie outside the array. Such circuitry may include row or column decoders, strobes (e.g., row array strobe, column array strobe), or sense amplifiers. Alternatively, such circuitry may be formed before, during, or after the formation of any layers shown in FIG. 5.

A lid 522 with a desiccant 524 is attached to the substrate 200 at locations (not shown) outside the array to form a substantially completed device. A gap 526 lies between the second electrode 502 and the desiccant 524. The materials used for the lid 522 and desiccant 524 and the attaching process are conventional.

FIG. 5 includes two pixels that each have red, green, and blue radiation-emitting components. The red radiation-emitting components include the red-doped regions 402, and the green components include the green-doped regions 404, and the blue components include undoped portions (substantially free of the red and green guest materials) of the organic active layer 250 lying between two of the first electrodes 220 and the second electrode 502.

In one embodiment (not shown), an organic material capable of emitting blue light is vapor deposited over at least part of a first organic layer. The organic materials for this vapor deposited, blue-emitting layer can include aluminum(III)bis(2-methyl-8-quinolinato)4-phenylphenolate ("BAlq"), diphenylanthracene derivatives, dinaphthylanthracene derivatives, 4,4-bis(2,2-diphenyl-ethen-1-yl)-biphenyl ("DPVBI"), 9,10-di-beta-naphthylanthracene, 9,10-di-(naphenthyl)anthracene, 9,10-di-(2-naphthyl)anthracene ("ADN"), 4,4'-bis(carbazol-9-yl)biphenyl ("CBP"), 9,10-bis-[4-(2,2-diphenylvinyl)-phenyl]-anthracene ("BDPVPA"), anthracene, 9,10-diphenylanthracence ("DPA"), N-arylbenzimidazoles (such as "TPBI"), 2-tert-butylphenyl-5-biphenyl-1,3,4-oxadiazole ("PBD"), 1,4-bis[2-(9-ethyl-3-carbazoyl)vinylenyl]benzene, 4,4'-bis[2-(9-ethyl-3-carbazoyl)vinylenyl]-1,1'-biphenyl, 9,10-bis[2,2-(9,9-fluorenylene)vinylenyl]anthracene, 1,4-bis[2,2-(9,9-fluorenylene)vinylenyl]benzene, 4,4'-bis[2,2-(9,9-fluorenylene)vinylenyl]-1,1'-biphenyl, perylene, substituted perylenes, tetra-tert-butylperylene ("TBPe") , bis(3,5-difluoro-2-(2-pyridyl)phenyl-(2-carboxypyridyl) iridium III ("F(Ir)Pic"), pyrene, substituted pyrenes, styrylamines, other organic small molecule materials capable of emitting blue light, and combinations thereof.
The vapor deposited layer of this embodiment can be formed from a single material, from a co-deposition of more than one material, as a multilayer of more than one material, or as a single layer with a continuously changing composition that is determined by the deposition parameters. This vapor deposited layer can be formed as a continuous layer or a patterned layer. In addition to providing blue emission, the vapor deposited layer can also function as an electron transport layer, an electron injection layer, a hole blocking layer, and combinations thereof.

### 6. Alternative Embodiments

FIG. 6 includes an illustration where each of the blue components includes a blue-doped region 606. The process for forming the doped regions 606 is similar to that described and shown with respect to FIGs. 3 and 4.

In still a further embodiment, the liquid compositions may be placed over a substrate before forming an organic layer. Referring to FIG. 7, first electrodes 220 are formed over the substrate 200. Well structures 730 are formed using a conventional process, such as coating a photoresist layer and patterning it. The well structures may have a thickness in a range of approximately 2-5 microns. The charge-transport layer 240 may be formed over the first electrodes 220 and between the well structures 730 using a technique previously described. Liquid compositions 302 and 304 are placed over the charge-transport layer 240 using any one or more of the techniques previously described. The liquid media within the liquid compositions 302 and 304 may or may not be evaporated at this time.

The organic active layer 250 is formed over the charge-transport layer 240 and between the well structures 730 as shown in FIG 8. The guest material(s) within the liquid compositions 302 and 304 may migrate into both the charge-transport layer 240 and the organic active layer 250 to form a red-doped charge-transport layer 842 and red-doped organic active layer 852 for the red organic electronic component 802, and form a green-doped charge-transport layer 844 and green-doped organic active layer 854 for the green organic electronic component 804. The blue organic electronic component 806 has the charge-transport layer 240 and organic active layer 250 substantially free of guest materials. The organic active layers 852, 854, and 250 can be cured to render the organic active layers 852, 854, and 250 substantially solid. The second electrode 502 and subsequent processing may be performed as previously described.

In this embodiment, processing latitude exists to allow the formation of the organic active layer 250 after placing the liquid compositions 302 and 304 over the first electrodes 220. The well structures 730 help to keep the guest materials within compositions 302 and 304 from migrating to undesired regions.

In a further embodiment (not shown), liquid compositions, including guest materials, may be placed on the first electrodes 220 before the organic layer 230 is formed. The liquid media within the liquid compositions may be evaporated to become substantially solid before the organic layer 230 is formed over the first electrodes 220. The organic layer 230 can include a liquid medium that can form a solution, dispersion, emulsion, or suspension with the guest materials and limit its lateral migration.

In still another embodiment, a filter layer can lie between the organic active layer 250 and a user side of the organic electronic device. The filter allows radiation at a wavelength or spectrum of wavelengths to be transmitted through the filter layer. The filter layer does not allow a significant amount of radiation outside such wavelength or spectrum of wavelengths to be transmitted. Therefore, the filter layer can "block" radiation at undesired wavelengths.

An organic layer 900 can be formed over the substrate 200 as illustrated in FIG. 9. The organic layer 900 may include one or more layers of nearly any organic material (e.g., a polymeric film) that is used to form part of the substrate 200. The organic layer 900 may theoretically have nearly any thickness (1 nm to several hundreds of microns or more). However, when the thickness is too thin, the filter layer may not be sufficient to provide a good quality filter layer. At the other end of the range, as the filter layer becomes thicker, transmission of radiation through the filter layer is reduced. In one embodiment, the organic layer 900 has a thickness in a range of approximately 1-10 microns.

The organic layer 900 can be formed by one or more of any number of different techniques including spin coating, casting, vapor deposition (chemical or physical), printing (ink jet printing, screen printing, solution dispense, or any combination thereof), other depositing technique, or any combination thereof for an organic material. Alternatively, the organic layer 900 can be formed over the substrate 200 using a mechanical process. One mechanical process may include using an adhesive layer (not shown) on the substrate 200 or organic layer 900 and placing the organic layer 900 near the substrate 200 so that the adhesive layer lies between the organic layer 900 and substrate 200. Alternatively, the organic layer 900 can be placed over the substrate 200 and heated to allow the organic layer 900 and substrate 200 to fuse together. The processes described are only two of potentially may other mechanic processes that may be used.

Any one or more of the processes as previously described regarding the liquid compositions can be used to introduce guest materials into the organic layer 900. Red-doped regions 902 include a red guest material, green-doped regions 904 include a green guest material, and the blue-doped regions 906 include a blue guest material.

Formation of the rest of the organic electronic device is similar to any of the processes previously described above except that guest materials may or may not be added to organic layer 930. In one embodiment, the organic layer 930 includes organic active layer 950 that may emit substantially white light. The red-doped regions 902 may allow red light, and not green light or blue light, to be transmitted through the organic layer 900 to the user side of the organic electronic device. The green-doped regions 904 and blue-doped regions 906 perform similar functions for green light and blue light, respectively.

If the organic electronic device includes radiation-responsive components, the red-doped regions 902 may allow red light, and not green light and blue light, to be transmitted through the organic layer 900 to the organic active layer 950. The green-doped regions 904 and blue-doped regions 906 perform similar functions for green light and blue light, respectively.

In a further embodiment (not shown), fabrication of the filter layer may be performed separate from substrate 200. The fabrication process for an organic layer, similar to organic layer 900, may be performed and the organic layer with filter regions may be attached to the substrate 200 before, during or after the formation of electronic components. In one embodiment, driver or other circuits may be formed over substrate 200 before the filter layer is attached. After the filter layer is attached, the organic layers (e.g., organic active layer) for organic electronic components may be formed. In this manner, the organic active layer may not be exposed to relatively higher temperatures that may be used to attach the filter layer to the substrate 200.

In another embodiment not shown, the charge transport layer 240 and not the organic active layer 250 may include the guest materials. Although the charge transport layer 240 is a filter layer in theory, the guest material in the charge transport layer 240 can help to get color emission or reception by the organic active layer 250 closer to the wavelengths as specified in the Commission Internationale de l'Éclairage ("CIE") standards.

In still another embodiment, the positions of the first and second electrodes may be reversed. The second electrode 502 may be closer to the substrate 200 compared to the first electrodes 220. If radiation is to be transmitted through the second electrode 502, the thickness of the second electrode 502 may be reduced to allow sufficient radiation (at least 70%) to be transmitted through it.

In yet another embodiment, radiation may be emitted or received through a side of the organic electronic device opposite the substrate 200 instead of or in addition to radiation being emitted or received through the substrate side of the organic electronic device. In such a device, each of the second electrode 502 and the lid 522 may allow at least 70% of the radiation to be emitted from or received by the organic active layer 250. The location of the desiccant 524 may be changed so that it does not overlie the first electrodes 220. Alternatively, the desiccant 524 may include one or more materials of a thickness(es) where at least 70% of the radiation to be emitted from or received by the organic active layer 250 to pass through the desiccant 524.

In yet another embodiment, the second electrode 502 may be replaced by a plurality of second electrodes. Any one or more of the components in FIG. 5 may have its own second electrode or share the second electrode with some or all other components in an array.

Nearly any organic electronic device having an organic active layer can use the doping techniques previously described. While FIG. 5 includes a configuration that may be used with an active matrix OLED display, the configuration may be changed for a passive matrix OLED display by orienting the first electrodes 220 into conductive strips having lengths extending in a first direction and changing the second electrode 502 into conductive strips having lengths extending in another direction substantially perpendicular to the first direction. Driver circuits (not shown in FIG. 5) may not be needed for the passive matrix OLED display. After reading this specification, skilled artisans will appreciate that other modifications may be made for other types of organic electronic devices to achieve the proper functions of such devices (e.g., sensor arrays, voltaic cells, etc.).

In yet a further embodiment, the organic layer 230, 852, 854, 900, or any combination thereof may be designed to emit, be responsive to, or transmit radiation at wavelength(s) outside the visible light spectrum. For example, one of the organic electronic components may be designed to have the organic active layer 250 or 750 emit or respond to UV, IR, other non-visible radiation, and any combination thereof. In another embodiment, radiation-emitting components and radiation-responsive components may be used in the same device. In still another embodiment, within the same organic electronic device, one or more the organic electronic components may emit or respond to radiation within the visible light spectrum, and one or more the organic electronic components may emit or respond to radiation outside the visible light spectrum (e.g., UV, IR, or both). The number of combinations is nearly limitless.

The concepts described herein can be used to affect organic layer that are not designed to emit, respond, or filter radiation. Such an application may be used to form circuit elements including transistors, resistors, capacitors, diodes and combinations thereof. The guest material may change an organic active layer's resistance or conductivity type (p-type or n-type). More specifically, the guest material may be used to adjust threshold voltages or gains of transistors, define current carrying electrodes (e.g., source regions, drain regions, source/drain regions, emitter regions, collector regions, inactive base regions, resistor contacts, capacitor contacts, and combinations thereof), form p-n junctions for capacitors and diodes, and combinations thereof. Note that these electronic components may be used in logic, amplifying, or other circuits and may or may not be used for their radiation-related properties.

### 7. Electronic Operation of the Organic Electronic Device

If the organic electronic components within the organic electronic device are radiation-emitting components, appropriate potentials are placed on the first electrodes 220 and second electrode 502. As one or more of the radiation-emitting components become sufficiently forward biased, such forward biasing can cause radiation to be emitted from the organic active layer 250. Note that one or more of the radiation-emitting components may be off during the normal operation of the organic electronic device. For example, the potentials and current used for the radiation-emitting components may be adjusted to change the intensity of color emitted from such components to achieve nearly any color within the visible light spectrum. Referring to the three first electrodes 220 closest to the right-hand side of FIG. 5, for red to be displayed, radiation-emitting component including doped region 402 will be on, while the other two radiation-emitting components are off. In a display, rows and columns can be given signals to activate the appropriate sets of radiation-emitting components to render a display to a viewer in a human-understandable form.

If the organic electronic components within the organic electronic device are radiation-responsive components, the radiation-responsive components may be reversed biased at a predetermined potential (e.g., second electrode 502 has a potential approximately 5-15 volts higher than the first electrode(s) 220). If radiation at the targeted wavelength or spectrum of wavelengths is received by the organic active layer, the number of carriers (i.e., electron-hole pairs) within the organic active layer increases and causes an increase in current as sensed by sense amplifiers (not shown) within the peripheral circuitry outside the array.

In a voltaic cell, such as a photovoltaic cell, light or other radiation can be converted to energy that can flow without an external energy source. The conductive members 220 and 502 may be connected to a battery (to be charged) or an electrical load. After reading this specification, skilled artisans are capable of designing the electronic components, peripheral circuitry, and potentially remote circuitry to best suit their particular needs for their particular organic electronic device.

### 8. Advantages

Unexpectedly, the processes described above can be used to form localized doped regions in an organic layer before or after the organic layer is formed where the guest material concentration gradient between the opposite surfaces of an organic layer (near the electrodes) is smaller compared to conventional diffusion processes, and without the substantial lateral migration as seen with many conventional diffusion processes. A substantial amount, if not all, of the guest material migrates into the organic layer. The guest material can be "pulled" into the organic layer and obviate the need to perform a thermal diffusion process. Therefore, problems with too much lateral diffusion should not occur. Also, "partial" diffusions (through only part of the organic layer) or steep concentration gradients for guest material through the thickness of an organic layer should not occur.

Compare the new process to a conventional process. In one conventional process, a guest material is diffused from an ink outside the organic layer, and no more than about 25% of the guest material enters the organic layer. The concentrations of the guest material near the first and second electrodes using this conventional process may be anywhere from a few to several orders of magnitude different. In the new processes described herein, the guest material concentrations near the first and second electrodes should be less than an order of magnitude different, and possibly less than that. The lower concentration gradient allows the organic electronic component(s) to be operated over a larger potential difference without causing a shift in an emission or reception spectrum. Therefore, better "gray-scale" intensity control can be seen. Also, the organic electronic device can be operated at higher voltages as the efficiency of such device decreases with age without a significant shift in the emission spectrum.

Compare the new process to a convention diffusion process where the diffusion is performed until the guest material concentration gradient is close to zero (concentrations near opposite sides of the organic layer are substantially equal. This conventional diffusion process allows too much lateral diffusion and makes its use within a high resolution array very difficult.

If a guest material thermal drive step is used with the conventional ink diffusion process to reduce the guest material concentration gradient, the guest material may also laterally migrate to a point where it could interfere with the proper radiation emission or reception of adjacent organic electronic components. In a filter layer, the filter may have undesired filtering characteristics. Because the new processes do not use a guest material drive step, the amount of lateral migration of guest material is kept relatively low.

The new processes can be used to introduce guest materials into an organic active layer and still achieve good efficiencies because an ink diffusion process is not required. Efficiencies higher than 0.4 cd/A can be achieved. In one embodiment, the efficiency of a red-doped organic active region is at least 1.1 cd/A, the efficiency of a green-doped organic active region is at least 3.0 cd/A, and the efficiency of a blue-doped organic active region is at least 1.1 cd/A. Even higher efficiencies are possible.

The new process is not as sensitive to thickness as the conventional ink diffusion process. Because the guest material concentration gradient is lower, the volume of liquid compound(s) can be adjusted for different thicknesses. The process allows for more flexibility if a different thickness of the organic layer is desired. The conventional ink diffusion process is highly sensitive to thickness changes due to the steep concentration gradient. Again, a thermal diffusion processing step is not required with the new process.

When forming organic electronic devices, more abrupt p-n junctions may be formed. The more abrupt junctions help to increase the breakdown voltage and improve capacitance at those junctions. Also, enhancement-mode and depletion-mode transistors may be formed using the same organic active layer. Smaller and more closely space electronic components may be made, and thereby increase circuit density. Additionally, less lateral diffusion allows smaller electronic components to be formed.

In one embodiment of the present invention, the liquid medium (media) of the liquid compound can interact with the organic layer, thus raising the viscosity of the resulting solution, dispersion, emulsion, or suspension. The increased viscosity helps to keep lateral motion under control as the liquid media (medium) and guest material(s) work their way through the thickness of the organic layer. Therefore, well structures are not required but may be used if desired. If well structures are not formed, process steps may be reduce, thereby saving production costs and potentially improving yields.

The new process can be performed using existing equipment and can be integrated into an existing process without substantial modification of the process. Therefore, the new process can be implemented without significant risk of having to learn and characterize new equipment or creating undue complications during process integration.

### EXAMPLES

The following specific examples are meant to illustrate and not limit the scope of the invention.

### EXAMPLE 1

This Example demonstrates that appropriate manipulation of physical properties of the organic active layer and the liquid composition provides organic electronic components in an organic electronic device without the need for banks or wells.

Organic electronic components are fabricated to include the following structure: ITO (first electrodes, or anodes) /buffer polymer/organic active/second electrode (cathode). The substrates are 30 x 30 mm (nominal) ITO coated glass. The charge transport layer is a PEDOT material (BAYTRON-P, Bayer AG, Germany). The organic active layers include a blue-emitting poly(spirobifluorene) material (a host material capable of emitting blue light without any guest materials). PEDOT is spin-coated onto a flat glass/ITO substrate at room temperature and then baked at approximately 200°C for approximately 5 minutes. The film thickness is approximately 150 nm, as measured with a Dektec surface profiler. The blue-color organic active layer is then deposited from approximately 0.5% anisole-o-xylene solution at approximately 1000 rpm, which results in a film thickness of approximately 70-100 nm.

A liquid composition includes a red guest material (a red-emitting poly(spirobifluorene) material, 1.1 %, 11 mg/ml) and liquid media including co-solvents of anisole:o-xylene:3,4-DMA. The liquid composition is dropped onto pre-defined areas with a single nozzle inkjet machine with a nozzle diameter of 30 microns, nominal. The spacing between each drop is set at approximately 90 microns and the spacing between the rows of the drops is approximately 200 nm. The drops do not coalesce, and remain at a fixed width governed by such parameters as drop volume and organic active layer thickness. The size of the round red dots is approximately 80 microns, or approximately one-third of the spacing between adjacent rows. The film is then baked at 120 °C for 10 approximately minutes. The second electrode is deposited using a thermal evaporator and contains approximately 3.5 nm Ba covered with approximately 500 nm aluminum. At a bias of approximately 4 V between the ITO and second electrode, the emission intensity is approximately 200 cd/m².

As an alternative, the red liquid composition is replaced with a green liquid composition. The red guest material is replace by one or more green guest materials (e.g. a Green 1300 Series polyfluorene, Dow Chemical Company, Midland, MI). The processing details and equipment used is substantially the same as previously describe. A similar pixel size is achieved with green emission zones.

This example demonstrates that the processes described herein can be used to fabricate organic electronic devices with multiple colors, (i.e., regions with only the host material of the organic active layer emit blue light, regions with host material and red guest material emit red light, and regions with the host material and green guest material emit green light.) This example also demonstrates that well structures are not needed to define emitting zones.

### EXAMPLE 2

An experiment similar to Example 1 is performed, using a full-color display with 200 micron pixel pitch, nominal. The diameter of the ink jet nozzle is reduced to approximately 20 micron, and a display with multiple colors in a pre-defined pattern is produced using this smaller diameter nozzle. The diameter of the red or green emitting zones is reduced to approximately 65 micron. Thus, this example demonstrates that the processes described herein can be used to fabricate full color displays with less than a 200 micron pitch.

### EXAMPLE 3

Full color displays with red, green and blue polymer lines are produced using a procedure similar to that described in Example 1. An ink-jet printer with 40 nozzles is used for defining color pixels. The diameter of these nozzles is approximately 35 microns and the step motion between each drop is approximately 85 microns. The substrate is 100 mm x 100 mm (4 inch x 4 inch), nominal with a display area of approximately 80 mm x 60 mm (3.2 inch x 2.4 inch). The substrate does not include any well structures. The red, green and blue color stripes indicate: (1) a line pattern can be achieved without using bank structures, and (2) a full-color display can be made with 100 pixels-per-inch (equivalent to 254 micron pitch).

Full color, active matrix displays are also fabricated with a substrate with thin-film-transistor pixel drivers. An organic active layer is constructed between the pixel drivers and the ITO contacts. As in Examples 1 and 2, bank structures are not required for color ink confinement.

### EXAMPLE 4

In this Example, a full color backlight device is produced with a totally planar structure (i.e., ITO is continuous, no pads or columns). Starting from an optically flat glass ITO substrate, PEDOT and an organic layer (a host material capable of emitting blue light) are spin coated onto the substrate (as previously described). Inkjet deposition is used to form lines of a red liquid composition and a green liquid composition. The lines are approximately 80 microns wide without any well structure used. This example clearly demonstrates the ability of the organic layer to limit spreading of the red and green polymer lines.

By changing the spacing of the drops (with constant drop volumes of approximately 30 picoliters), the line widths can be varied from approximately 80 microns (at a drop spacing of 85 microns) to approximately 150 microns (at a drop spacing of 30 microns) making this process suitable for the production of larger area displays. Because the drops at larger drop spacings are relatively isolated from each other, the lateral spreading of the liquid compositions is limited by the volume of the individual drops and the line width is narrower. Conversely, when the drops are closer together there is more overlap and interaction between liquid compositions of adjacent drops, promoting greater lateral diffusion of each individual drop, resulting in a wider line width. In this situation, where the drops are deposited closer together, the total volume of liquid composition deposited in one line of red or green liquid composition is greater since a greater number of drops are deposited for a single line.

Similarly, a lower solubility host layer may result in greater lateral diffusion of the liquid composition since a larger volume of liquid composition may be required to allow the guest material to diffuse fully and uniformly through the thickness of the host layer.

### EXAMPLE 5

The color stability can be maintained over 2-3 orders of magnitude variation in current for a full-color display, allowing for gray scale control for each color without a significant shift in emission spectrum.

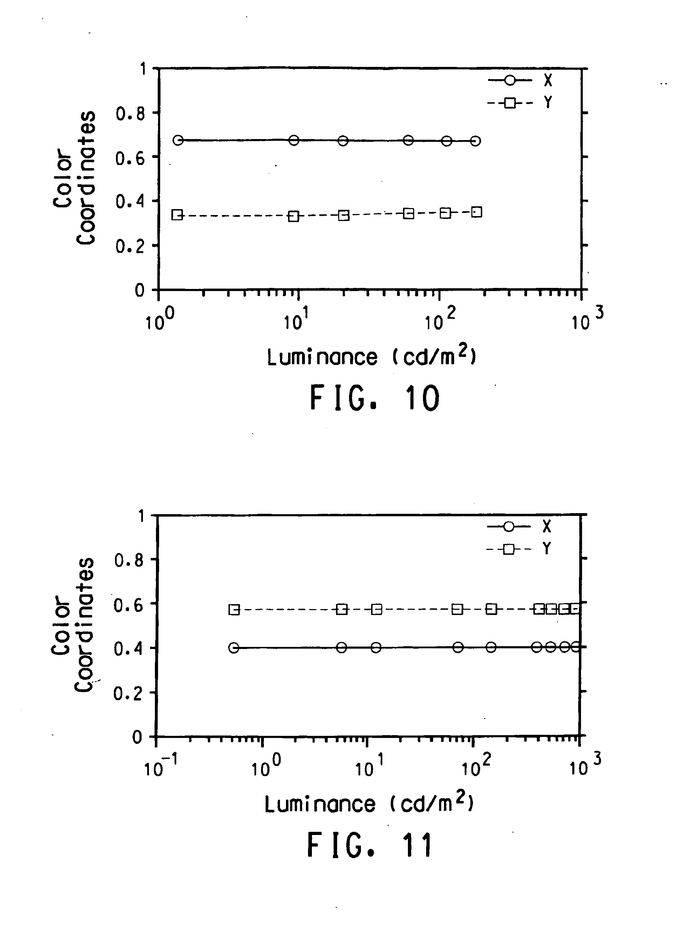

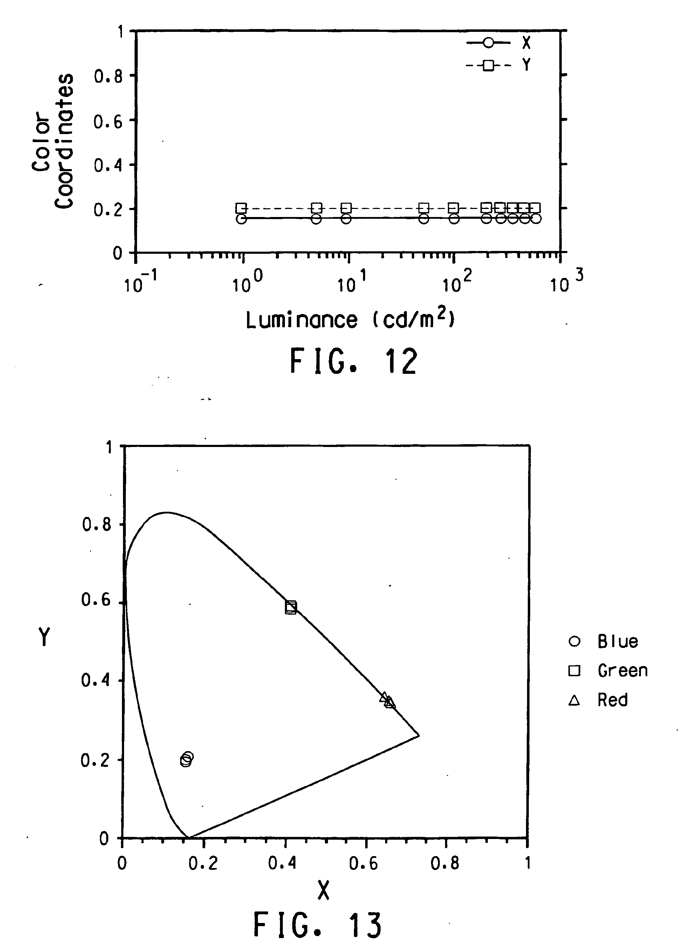

Red-emitting and green-emitting components are prepared in a similar procedure as that described in Example 1. A blue-emitting component is also made by spin coating without inkjet printing a guest material. The emission characteristics of organic electronic components are measured using a color analyzer (Chroma Model 71701) over a broad intensity range. The results are shown in FIGs. 10-12. The blue component shows color coordinates at x of approximately 0.16 and y of approximately 0.20 in FIG. 12. The color remains stable over 3 orders of magnitude. The colors of the red and green components show similar color stability over 2-3 orders of intensity range (driving current changed over similar scales) in FIGs. 10 and 11, respectively. These results are also demonstrated in the CIE1931 chromaticity chart as shown in FIG. 13. The color stabilities of the green and red components, which have guest materials, are similar to that of the blue components, which is substantially free of guest materials.

These results demonstrate that the green and red guest materials migrate into the organic active layer with relatively uniform concentration profiles. For current varying by 2-3 orders of magnitude and a device recombination zone in the doped organic active layer, the color coordinates (and thus the emission profile) remain constant, in contrast to the dramatic color changes observed by known processes.

The demonstrated color stability over 2-3 orders of magnitude variation in current allows for a full-color display to be powered by controlling current (and thus intensity) with over 6 bits (64 levels), 8 bits (256 levels) and even 10 bits (1024 levels) gray levels for each color. In contrast, the gray scale control of color pixels in presently known devices is powered by other means (such as time domain) with a fixed emission peak intensity (to fix the color).

### EXAMPLE 6

A continuous layer of small molecule electron transport materials can be vapor deposited onto organic layers formed from liquid compositions.

In this Example, the PEDOT hole transport layer is spin-coated onto the glass/ITO substrate at room temperature, at approximately 1500 rpm for approximately 1 minute, and then baked at approximately 180°C for approximately 10 minutes. The thickness of the PEDOT layer is approximately 100 nm. As in Example 1, the blue-emitting poly(spirobifluorene) organic active layer is then spin-coated from solution to form a continuous layer with a thickness of approximately 70-100 nm. Once again, the blue-emitting layer acts as a host for the red and green guest materials that are inkjet deposited from liquid compositions. A conventional thermal vapor deposition technique is then used to form a first electron transport layer of 9,10-diphenylanthracene ("DPA") and a second electron transport layer of aluminum tris(8-hydroxyquinoline) ("Alq"). The electron transport materials are vacuum deposited onto the electroluminescent organic active layer at a pressure of approximately 10⁻⁷ Torr and form a continuous layer. In each vapor deposition process, the source material is heated to approximately 200 to 250°C to form a vapor and transports as a gas to the target, where it condenses to form a layer. The temperature of the target is approximately room temperature. The second electrode is also deposited as a continuous layer using a thermal evaporator and contains approximately 0.9 nm of LiF followed by approximately 200 nm of aluminum. Table 1 summarizes the results of separate red, green and blue devices.

**Table 1**

| Device | Emitter | DPA (nm) | Alq (nm) | Color coordinates | EL Efficiency (cd/A) |
|---|---|---|---|---|---|
| A | Red | 11 | 8 | x=0.66, y=0.33 | 0.6 |
| B | Green | 11 | 8 | x=0.38, y=0.58 | 5.6 |
| C | Blue | 16 | 10 | x=0.17, y=0.23 | 2.8 |
| D | Blue | 4.5 | 3.7 | x=0.17, y=0.22 | 3.7 |

This Example demonstrates that a continuous layer of small molecule electron transport materials can be vapor deposited onto organic layers formed from a liquid composition to form OLED devices with high efficiencies. In addition, the device performance can be tuned and enhanced by varying the electron transport layer.

Although the vapor deposited DPA material is a fluorescent blue-emitter (with color coordinates of approximately x=0.17 and y=0.28), the spectral luminance of Devices C and D are characteristic of the blue-emitting poly(spirobifluorene) material of the host organic active layer and not characteristic of DPA.

### EXAMPLE 7

Device performance can be further enhanced by varying the hole transport layer.

HT1 (a 1:1 weight ratio blend of BAYTRON-P VP AI 4083 and BAYTRON-P VP CH8000, both from Bayer AG, Germany), HT2 (a PEDOT/Nafion®, where Nafion® is a polymeric perfluorosulfonic acid, as described in published PCT application WO 2004/029128), and HT3 (a poly-[1,4-phenylene-(1-naphthyl)imino-1,4-phenylene-hexafluoroisopropylidene-1,4-phenylene-imino-(1-naphthyl)-1,4-phenylene]), and combinations thereof can be used in place of the BAYTRON-P hole transport layer of Example 6. In this Example the hole transport layer ("HTL") is deposited onto the glass/ITO substrate as a single layer of a material composition, or as a first layer of a first material composition followed by a second layer of a second material composition. The red, green, and blue electroluminescent layers deposited from liquid compositions, the electron transport layer deposited by vapor deposition (DPA/Alq) and the cathode layer (LiF/Al) are formed as in Example 6. Table 2 summarizes the performance of devices for this Example.

**Table 2**

| Device | Emitter | 1^{st} HTL | 2^{nd} HTL | Color coordinates | EL Efficiency (cd/A) |
|---|---|---|---|---|---|
| A | Red | HT2 | HT3 | x=0.662, y=0.325 | 2.0 |
| B | Red | HT2 | none | x=0.663, y=0.327 | 2.2 |
| C | Red | HT1 | HT3 | x=0.659, y=0.329 | 1.5 |
| D | Red | HT1 | none | x=0.661, y=0.328 | 1.7 |
| E | Green | HT2 | HT3 | x=0.391, y=0.577 | 9.5 |
| F | Green | HT2 | none | - | - |
| G | Green | HT1 | HT3 | x=0.402, y=0.560 | 8.8 |
| H | Green | HT1 | none | x=0.396, y=0.568 | 6.8 |
| I | Blue | HT2 | HT3 | x=0.189, y=0.283 | 5.8 |
| J | Blue | HT2 | none | x=0.178, y=0.281 | 5.3 |
| K | Blue | HT1 | HT3 | x=0.173, y=0.233 | 4.1 |
| L | Blue | HT1 | none | x=0.174, y=0.235 | 3.8 |

As can be seen in Table 2, further enhancement of the device performance can be achieved by changing the hole transport layer. In addition, modifying the hole transport layer can improve the processing characteristics for the device manufacture by improving the processing compatibility of the surface of the hole transport layer with the liquid compositions containing the electroluminescent materials (e.g., improved wetting of a hole transport layer by a liquid composition).

### EXAMPLE 8

An active matrix full-color display device with a 4 inch QVGA format (320 x RGB x 240 pixels) can be made with 85 x 255 micron subpixels. The red and green subpixels are formed following processes similar to those used in Example 7. The blue subpixels are formed with the blue luminescence provided by a vapor deposited organic layer of a small molecule blue-emitting material (e.g., 9,10-diphenylanthracene, DPA).

Onto a glass/ITO substrate with a patterned anode layer, a continuous first hole transport layer of HT2 (PEDOT/Nafion®, approximately 100 nm) and a continuous second hole transport layer of HT3 (a poly-[1,4-phenylene-(1-naphthyl)imino-1,4-phenylene-hexafluoroisopropylidene-1,4-phenylene-imino-(1-naphthyl)-1,4-phenylene]), approximately 30 nm) can be formed using a spin-coating technique. The HT3 layer also functions as a host layer for the red and green guest materials which can be deposited into their corresponding subpixels from a liquid composition using a precision deposition technique (e.g. ink jet printing). The red and green guest materials are deposited and diffuse into the HT3 host material. Next, a continuous layer of DPA (approximately 11 nm) and a continuous layer of Alq (approximately 10 nm) can be formed by vapor deposition at 10⁻⁷ Torr. Finally a continuous cathode layer is thermally deposited and can comprise a first layer of approximately 1.2 nm of LiF followed by a second layer of approximately 200 nm of aluminum.

In the completed device of this Example, the red, green, and blue emission for the three different subpixels are characteristic of the red guest material deposited from a liquid composition (a red-emitting poly(spirobifluorene)), the green guest material deposited from a liquid composition (a green-emitting polyfluorene), and the blue-emitting DPA that is vapor deposited as a continuous layer, respectively.

### EXAMPLE 9

The hole transport layer HT3 in Examples 7 and 8 can be made via the following synthetic pathway.
Polymer obtained from monomer 1.

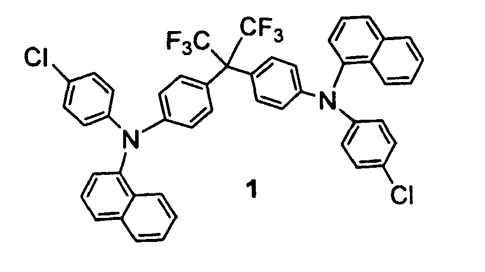

### Synthesis of monomer 1

Synthetic pathway to compound 1 is shown below.

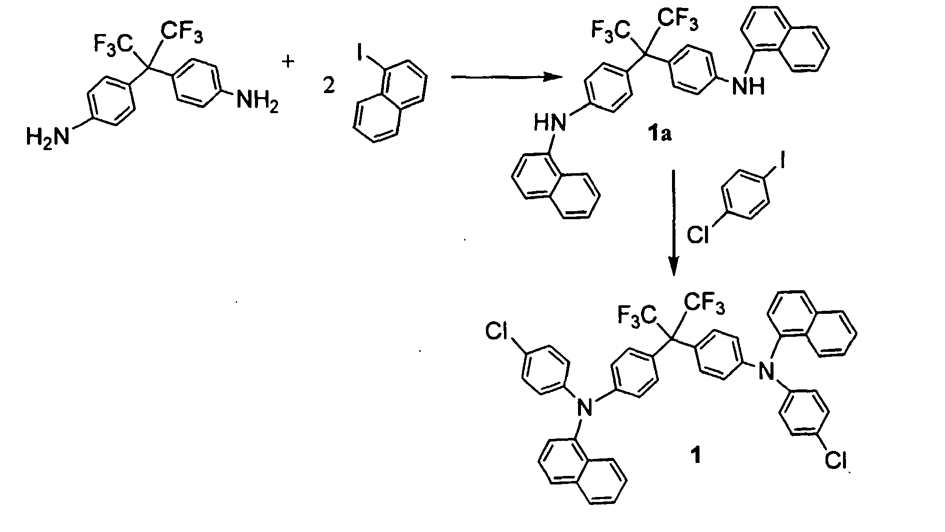

All reactions were performed under a nitrogen atmosphere and the reaction flask was kept away from room light. To a toluene (anhydrous, 300 mL) solution of 4,4'-(hexaflouroisopropylidene)dianiline (15.0 g), 1-iodonaphthalene (22.9 g) and NaO^{t}Bu (12.95 g), a mixture of tris(dibenzylideneacetone) dipalladium (4.12 g) and P^{t}Bu₃ (2.28 g) was added. The resulting reaction mixture was stirred at room temperature for five days, after which it was filtered through a plug of celite and washed with toluene (3x500 mL). The volatiles were removed by rotorary evaporation and the product was purified by column chromatography (silica) using EtOAc/hexane (1:5) followed by crystallization from CH₂Cl₂/hexane to yield **1a** in 67% yield (17.6 g).

A toluene (anhydrous, 480 mL) solution of **1a** (17.6 g) was then mixed with 1-chloro-4-iodobenzene (28.6 g), NaOtBu (8.65 g), tris(dibenzylideneacetone) dipalladium (2.20 g) and 1,1'-bis(diphenyphosphino)ferrocene (2.66 g). The resulting reaction mixture was heated to 100C for 48hrs, after which it was filtered through a plug of celite and washed with toluene (4x250 mL). The volatiles were removed and the product was purified by column chromatography (silica) using 1 L hexane followed by 15% CH₂Cl₂/hexane to give 1 as a white powder in 64% (15.4 g) yield.

### Polymerization of 1

Bis(1,5-Cyclooctadiene)-nickel-(0) (3.334 g, 12.12 mmol) was added to a N,N-dimethylformamide (anhydrous, 15 mL) solution 2,2'-bipyridyl (1.893 g, 12.12 mmol) and 1,5-cyclooctadiene (1.311 g, 12.12 mmol). The resulting mixture was heated to 60C for 30 min. The oil bath temperature was then raised to 70C and a toluene (anhydrous, 60 mL) solution of 1 (4.846 g ,6.0 mmol) was added rapidly to the stirring catalyst mixture. The mixture was stirred at 70C for 92 hours. After the reaction mixture cooled to room temperature, it was poured, slowly, with vigorous stirring into 600 mL of an acetone/methanol (50:50 by volume) mixture containing ~30 mL conc. HCl. A light-gray fiberous precipitate formed which partially broke-up during stirring. The mixture was stirred for one hour and the solid was isolated by filtration. The solid was dissolved in ~200 mL of chloroform and was poured with vigorous stirring, into 1200 mL of an acetone/methanol (50:50) mixture containing ~30 mL conc. HCl. A light-gray fiberous mass formed, which was stirred for one hour and isolated by filtration. The solid was again dissolved in ~200 mL chloroform, passed through a bed (~3-4 cm) of silica gel 60. The filter bed was rinsed with ~400 mL chloroform and the combined chloroform solutions were concentrated to ~150 - 200 mL and poured, with vigorous stirring into 1600 mL of acetone/methanol (50:50 by volume). A slightly off-white fiberous precipitate formed, which stirred for one hour. The solid was isolated by filtration and was dried under vacuum overnight. The solid was dissolved in tetrahydrofuran (250 mL) and then slowly poured with vigorous stirring into 1500 mL of ethyl acetate. The polymer precipitated out as a slightly off-white fiberous slurry. After stirring this mixture for one hour the precipirate was isolated by filtration. This solid was re-dissolved on more time in tetrahydrofuran (220 mL), filtered through a 0.2 um syringe filter (PTFE filter membrane) and poured, slowly, with vigorous stirring into 1200 mL of methanol. The polymer precipitated out as a white fiberous slurry, which was isolated by filtration. After drying the resulting material under vacuum overnight 3.31 g (75 %) of polymer was isolated. GPC (THF, room temperature): Mn = 92,000; Mw = 219,900; Mw/Mn = 2.39.

### EXAMPLE 10

The electronic structure of HT3 was measured using Ultraviolet Photoelectron Spectroscopy ("UPS"), optical absorption spectroscopy, and electrochemical redox measurements. The LUMO and HOMO of HT3 are approximately 2.0 eV and approximately 5.7 eV, respectively. Since the LUMO of the red, green and blue emitters (approximatey 3.1 eV, approximately 2.9 eV, and approximately 2.7 eV, respectively) are all larger than the LUMO of HT3, the HT3 serves as an effective electron blocking layer (preventing electron transport from the emitting layer to the anode) in addition to being able to transport holes from the anode to the emitting layer. In contrast, the primary function of HT1 and HT2, when incorporated into the devices of Examples 7 and 8, is to facilitate injection of holes into the emitting layer.

Benefits, other advantages, and solutions to problems have been described above with regard to specific embodiments. However, the benefits, advantages, solutions to problems, and any element(s) that may cause any benefit, advantage, or solution to occur or become more pronounced are not to be construed as a critical, required, or essential feature or element of any or all the claims.

## Claims

1. A process for forming organic layers comprising:
forming a first organic layer comprising at least one organic material over a substrate;
incorporating at least one guest material into the first organic layer by placing a first liquid composition over a first portion of the first organic layer, wherein:
the first liquid composition comprises at least a first guest material and a first liquid medium;
the first liquid composition comes in contact with the first organic layer; and
a substantial amount of the first guest material migrates into the first organic layer; and
vapor depositing a second organic layer over at least part of the first organic layer, wherein the second organic layer comprises at least one organic material capable of emitting blue light.

2. The process of claim 1, wherein the first organic layer is a substantially solid layer before placing the first liquid composition over the first organic layer.

3. The process of claim 1, wherein after placing the first liquid composition over the first organic layer, substantially all of the first guest material migrates into the first organic layer.

4. The process of claim 1, wherein the first organic layer comprises a material capable of emitting blue light.

5. The process of claim 1, wherein the first organic layer comprises a hole transport material.

6. The process of claim 1, wherein the first organic layer comprises an electron blocking material.

7. The process of claim 1, wherein the first organic layer forms a continuous layer.

8. The process of claim 1, wherein the second organic layer forms a continuous layer.

9. The process of claim 1, wherein the second organic layer comprises an electron transport material.

10. The process of claim 1, wherein the second organic layer comprises a hole blocking material.

11. The process of claim 1, wherein the second organic layer is substantially free of the first guest material.

12. The process of claim 1, wherein placing the first liquid composition over the first organic layer is performed without a well structure present over the substrate.

13. The process of claim 1, further comprising forming a well structure over the substrate before forming the first organic layer over the substrate.

14. The process of claim 1, wherein placing the first liquid composition over the first organic layer is performed using a precision deposition technique.

15. A display formed by the process of claim 1, wherein:
the display has radiation-emitting components including at least a first radiation-emitting component, a second radiation-emitting component, and a third radiation-emitting component.

16. The display of claim 15, wherein:
the display emits radiation over substantially all of the visible light spectrum;
the first radiation-emitting component has a first emission maximum within a red light spectrum;
the second radiation-emitting component has a second emission maximum within a green light spectrum; and
the third radiation-emitting component has a third emission maximum within a blue light spectrum.

17. An organic electronic device formed by the process of claim 1.

18. The organic electronic device of claim 17 comprising:
a substrate;
a first continuous organic layer overlying the substrate, wherein the first continuous organic layer comprises a first portion and a second portion;
a first guest material, wherein a substantial amount of the first guest material lies within the first continuous organic layer, wherein:
at least part of the first guest material lies within the first portion;
the second portion is substantially free of the first guest material;
a second continuous organic layer overlying the substrate, wherein the second continuous organic layer comprises a third portion and a fourth portion;
a second guest material, wherein a substantial amount of the second guest material lies within the second continuous organic layer, wherein:
at least part of the second guest material lies within the third portion; and
the fourth portion is substantially free of the second guest material.

19. The organic electronic device of claim 18, wherein the first continuous organic layer comprises a hole transport material.

20. The organic electronic device of claim 18, wherein the first continuous organic layer comprises an electron blocking material.

21. The organic electronic device of claim 18, wherein the second continuous organic layer comprises an electron transport material.

22. The organic electronic device of claim 18, wherein the second continuous organic layer comprises a hole blocking material.

23. The organic electronic device of claim 18, wherein:
the first continuous organic layer further comprises a fifth portion;
a substantial amount of a third guest material lies within the first continuous organic layer;
at least part of the third guest material lies within the fifth portion; and
the second portion is substantially free of the third guest material.

## Patentansprüche

1. Verfahren zur Bildung organischer Schichten, das aufweist:
Bildung einer ersten organischen Schicht, die mindestens ein organisches Material aufweist, über einem Substrat;
Einlagern mindestens eines Gastmaterials in die erste organische Schicht durch Aufbringen einer ersten flüssigen Zusammensetzung über einem ersten Abschnitt der ersten organischen Schicht, wobei:
die erste flüssige Zusammensetzung mindestens ein erstes Gastmaterial und ein erstes flüssiges Medium aufweist;
die erste flüssige Zusammensetzung in Kontakt mit der ersten organischen Schicht kommt; und
eine wesentliche Menge des ersten Gastmaterials in die erste organische Schicht wandert; und
Aufdampfen einer zweiten organischen Schicht zumindest auf einen Teil der ersten organischen Schicht, wobei die zweite organische Schicht mindestens ein organisches Material aufweist, das blaues Licht emittieren kann.

2. Verfahren nach Anspruch 1, wobei die erste organische Schicht eine weitgehend feste Schicht ist, bevor die erste flüssige Zusammensetzung über der ersten organischen Schicht aufgebracht wird.

3. Verfahren nach Anspruch 1, wobei nach dem Aufbringen der ersten flüssigen Zusammensetzung über der ersten organischen Schicht im wesentlichen das gesamte erste Gastmaterial in die erste organische Schicht wandert.

4. Verfahren nach Anspruch 1, wobei die erste organische Schicht ein Material aufweist, das blaues Licht emittieren kann.

5. Verfahren nach Anspruch 1, wobei die erste organische Schicht ein Löchertransportmaterial aufweist.

6. Verfahren nach Anspruch 1, wobei die erste organische Schicht ein elektronenblockierendes Material aufweist.

7. Verfahren nach Anspruch 1, wobei die erste organische Schicht eine geschlossene Schicht bildet.

8. Verfahren nach Anspruch 1, wobei die zweite organische Schicht eine geschlossene Schicht bildet.

9. Verfahren nach Anspruch 1, wobei die zweite organische Schicht ein Elektronentransportmaterial aufweist.

10. Verfahren nach Anspruch 1, wobei die zweite organische Schicht ein löcherblockierendes Material aufweist.

11. Verfahren nach Anspruch 1, wobei die zweite organische Schicht im wesentlichen frei von dem ersten Gastmaterial ist.

12. Verfahren nach Anspruch 1, wobei das Aufbringen der ersten flüssigen Zusammensetzung über der ersten organischen Schicht ohne eine über dem Substrat vorhandene Ätzgrubenstruktur ausgeführt wird.

13. Verfahren nach Anspruch 1, das ferner die Ausbildung einer Ätzgrubenstruktur über dem Substrat vor der Bildung der ersten organischen Schicht über dem Substrat aufweist.

14. Verfahren nach Anspruch 1, wobei das Aufbringen der ersten flüssigen Zusammensetzung über ersten organischen Schicht unter Anwendung eines Präzisionsbeschichtungsverfahrens ausgeführt wird.

15. Bildschirm, der durch das Verfahren nach Anspruch 1 gebildet wird, wobei:
der Bildschirm strahlungsemittierende Komponenten aufweist, zu denen mindestens eine erste strahlungsemittierende Komponente, eine zweite strahlungsemittierende Komponente und eine dritte strahlungsemittierende Komponente gehören.

16. Bildschirm nach Anspruch 15, wobei:
der Bildschirm Strahlung im wesentlichen über das gesamte sichtbare Lichtspektrum emittiert;
die erste strahlungsemittierende Komponente ein erstes Emissionsmaximum innerhalb eines roten Lichtspektrums aufweist;
die zweite strahlungsemittierende Komponente ein zweites Emissionsmaximum innerhalb eines grünen Lichtspektrums aufweist;
die dritte strahlungsemittierende Komponente ein drittes Emissionsmaximum innerhalb eines blauen Lichtspektrums aufweist.

17. Organisches elektronisches Bauelement, das durch das Verfahren nach Anspruch 1 gebildet wird.

18. Organisches elektronisches Bauelement nach Anspruch 17, das aufweist:
ein Substrat;
eine das Substrat überlagernde erste geschlossene organische Schicht, wobei die erste geschlossene organische Schicht einen ersten Abschnitt und einen zweiten Abschnitt aufweist;
ein erstes Gastmaterial, wobei ein wesentlicher Anteil des ersten Gastmaterials innerhalb der ersten geschlossenen organischen Schicht liegt, wobei:
mindestens ein Teil des ersten Gastmaterials innerhalb des ersten Abschnitts liegt;
der zweite Abschnitt im wesentlichen frei von dem ersten Gastmaterial ist;
eine das Substrat überlagernde zweite geschlossene organische Schicht; wobei die zweite geschlossene organische Schicht einen dritten Abschnitt und einen vierten Abschnitt aufweist;
ein zweites Gastmaterial, wobei ein wesentlicher Anteil des zweiten Gastmaterials innerhalb der zweiten geschlossenen organischen Schicht liegt, wobei:
mindestens ein Teil des zweiten Gastmaterials innerhalb des dritten Abschnitts liegt;
der vierte Abschnitt im wesentlichen frei von dem zweiten Gastmaterial ist.

19. Organisches elektronisches Bauelement nach Anspruch 18, wobei die erste geschlossene organische Schicht ein Löchertransportmaterial aufweist.

20. Organisches elektronisches Bauelement nach Anspruch 18, wobei die erste geschlossene organische Schicht ein elektronenblockierendes Material aufweist.

21. Organisches elektronisches Bauelement nach Anspruch 18, wobei die zweite geschlossene organische Schicht ein Elektronentransportmaterial aufweist.

22. Organisches elektronisches Bauelement nach Anspruch 18, wobei die zweite geschlossene organische Schicht ein löcherblockierendes Material aufweist.

23. Organisches elektronisches Bauelement nach Anspruch 18, wobei:
die erste geschlossene organische Schicht ferner einen fünften Abschnitt aufweist;
ein wesentlicher Anteil eines dritten Gastmaterials innerhalb der ersten geschlossenen organischen Schicht liegt;
mindestens ein Teil des dritten Gastmaterials innerhalb des fünften Abschnitts liegt; und
der zweite Abschnitt im wesentlichen frei von dem dritten Gastmaterial ist.

## Revendications

1. Procédé pour former des couches organiques comprenant les étapes consistant à :
former une première couche organique comprenant au moins un matériau organique sur un substrat ;
incorporer au moins un matériau invité dans une première couche organique en plaçant une première composition liquide sur une première partie de la première couche organique, dans lequel :
la première composition liquide comprend au moins un premier matériau invité et un premier milieu liquide ;
la première composition liquide vient en contact avec la première couche organique ; et
une quantité substantielle du premier matériau invité migre dans la première couche organique ; et
déposer en phase vapeur une seconde couche organique sur au moins une partie de la première couche organique, dans lequel la seconde couche organique comprend au moins un matériau organique capable d'émettre une lumière bleue.

2. Procédé selon la revendication 1, dans lequel la première couche organique est une couche sensiblement solide avant de placer la première composition liquide sur la première couche organique.

3. Procédé selon la revendication 1, dans lequel après avoir placé la première composition liquide sur la première couche organique, sensiblement la totalité du premier matériau invité migre dans la première couche organique.

4. Procédé selon la revendication 1, dans lequel la première couche organique comprend un matériau capable d'émettre une lumière bleue.

5. Procédé selon la revendication 1, dans lequel la première couche organique comprend un matériau de transport de trous.

6. Procédé selon la revendication 1, dans lequel la première couche organique comprend un matériau de blocage des électrons.

7. Procédé selon la revendication 1, dans lequel la première couche organique forme une couche continue.

8. Procédé selon la revendication 1, dans lequel la seconde couche organique forme une couche continue.

9. Procédé selon la revendication 1, dans lequel la seconde couche organique comprend un matériau de transport des électrons.

10. Procédé selon la revendication 1, dans lequel la seconde couche organique comprend un matériau de blocage des trous.

11. Procédé selon la revendication 1, dans lequel la seconde couche organique est sensiblement dépourvue du premier matériau invité.

12. Procédé selon la revendication 1, dans lequel le placement de la première couche liquide sur la première couche organique est effectué sans une structure de puits présente sur le substrat.

13. Procédé selon la revendication 1, comprenant, en outre, la formation d'une structure de puits sur le substrat avant la formation de la première couche organique sur le substrat.

14. Procédé selon la revendication 1, dans lequel le placement de la première composition liquide sur la première couche organique est effectué en utilisant une technique de dépôt de précision.

15. Affichage formé par le procédé selon la revendication 1, dans lequel :
l'affichage comprend des composants émettant un rayonnement incluant au moins un premier composant émettant un rayonnement, un second composant émettant un rayonnement et un troisième composant émettant un rayonnement.

16. Affichage selon la revendication 15, dans lequel :
l'affichage émet un rayonnement sur sensiblement tout le spectre de lumière visible ;
le premier composant d'émission de rayonnement a une première émission maximale à l'intérieur du spectre de lumière rouge ;
le second composant d'émission de rayonnement a une seconde émission maximale à l'intérieur du spectre de lumière verte ; et
le troisième composant d'émission de rayonnement a une troisième émission maximale à l'intérieur du spectre de lumière bleue.

17. Dispositif électronique organique formé par le procédé selon la revendication 1.

18. Dispositif électronique organique selon la revendication 17 comprenant :
un substrat ;
une première couche organique continue recouvrant le substrat, dans lequel la première couche organique continue comprend une première partie et une seconde partie ;
un premier matériau invité, dans lequel une quantité substantielle du premier matériau invité se trouve à l'intérieur de la première couche organique continue, dans lequel :
au moins une partie du premier matériau invité se trouve à l'intérieur de la première partie ;
la seconde partie est sensiblement dépourvue du premier matériau invité ;
une seconde couche organique continue recouvrant le substrat, dans lequel la seconde couche organique continue comprend une troisième partie et une quatrième partie ;
un second matériau invité, dans lequel une quantité substantielle du second matériau invité se trouve à l'intérieur de la seconde couche organique continue,
dans lequel :
au moins une partie du second matériau invité se trouve à l'intérieur de la troisième partie ; et
la quatrième partie est sensiblement dépourvue du second matériau invité.

19. Dispositif électronique organique selon la revendication 18, dans lequel la première couche organique continue comprend un matériau de transport des trous.

20. Dispositif électronique organique selon la revendication 18, dans lequel la première couche organique continue comprend un matériau de blocage des électrons.

21. Dispositif électronique organique selon la revendication 18, dans lequel la seconde couche organique continue comprend un matériau de transport des électrons.

22. Dispositif électronique organique selon la revendication 18, dans lequel la seconde couche organique continue comprend un matériau de blocage des trous.

23. Dispositif électronique organique selon la revendication 18, dans lequel :
la première couche organique continue comprend, en outre, une cinquième partie ;
une quantité substantielle du premier matériau invité se trouve à l'intérieur de la première couche organique continue ;
au moins une partie du troisième matériau invité se trouve à l'intérieur de la cinquième partie ; et
la seconde partie est sensiblement dépourvue du troisième matériau invité.
